(19) Europäisches Patentamt
European Patent Office
Office européen des brevets

(11) **EP 4 075 475 A1**

(12) **EUROPEAN PATENT APPLICATION**
published in accordance with Art. 153(4) EPC

(43) Date of publication:
**19.10.2022  Bulletin 2022/42**

(21) Application number: **20903239.0**

(22) Date of filing: **17.12.2020**

(51) International Patent Classification (IPC):
**H01J 37/153** (2006.01)

(52) Cooperative Patent Classification (CPC):
**H01J 37/153**

(86) International application number:
**PCT/JP2020/047288**

(87) International publication number:
**WO 2021/125297 (24.06.2021 Gazette 2021/25)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **17.12.2019  JP 2019227788**

(71) Applicant: **Inter-University Research Institute Corporation**
**National Institutes of Natural Sciences**
**Tokyo 181-8588 (JP)**

(72) Inventors:
• **MATSUDA, Hiroyuki**
**Okazaki-shi, Aichi 444-8585 (JP)**
• **MATSUI, Fumihiko**
**Okazaki-shi, Aichi 444-8585 (JP)**

(74) Representative: **Fleck, Hermann-Josef**
**Jeck, Fleck & partner mbB**
**Patentanwälte**
**Klingengasse 2**
**71665 Vaihingen/Enz (DE)**

(54) **SPHERICAL ABERRATION ADJUSTMENT CATHODE LENS, SPHERICAL ABERRATION CORRECTION ELECTROSTATIC LENS, ELECTRON SPECTROSCOPE, AND PHOTOEMISSION ELECTRON MICROSCOPE**

(57) Provided is an electrostatic lens that allows an acceptance angle of approximately ±90° or a very large acceptance angle over a wide energy range from 0 to 2 keV. In a cathode lens 19 configured of a point source electrode 12 in which a point source 11 is arranged on a lens axis and a extraction electrode 13 for extracting charged particles generated from the point source, the point source electrode is a planar electrode perpendicular to the lens axis (or such a planar electrode additionally having a convex portion axially symmetrical with respect to the lens axis direction in which the point source is arranged in the upper center of the convex portion), the extraction electrode has a protruding wall portion 13b that protrudes axially symmetrically in the axial direction from a base surface 13a, which is perpendicular to the lens axis, and that has an opening surface formed at the end portion thereof, and a planar grid portion 16 is formed at the opening surface, or an opening surface is formed at a tapered protruding wall portion extending from the end portion of the protruding wall portion and expanding outward and at the expanded end portion.

Fig.1

EP 4 075 475 A1

**Description**

**[Technical Field]**

The present invention relates to an electrostatic lens to accept and focus charged particles emitted from a sample by irradiation with light such as ultraviolet rays and X-rays or an electron beam, photoelectron spectroscopy apparatuses such as ultraviolet photoelectron spectroscopy (UPS) and X-ray photoelectron spectroscopy (XPS), an Auger electron spectroscopy apparatus, an angle-resolved photoelectron spectroscopy apparatus, a photoelectron diffraction device, and a photoemission electron microscope.

**[Background Art]**

In an electron spectrometer, sensitivity is one of the most important performances along with energy resolution. In the measurement of photoelectrons or Auger electrons, when the signal is very weak and almost buried in noise, it is necessary to significantly increase the accumulation time in order to obtain a sufficient signal-to-noise ratio (SN ratio). However, in this case, not only cannot the measurement be performed efficiently, but it is also often the case that the continuous measurement time must be limited due to time constraints such as the utilization time of the synchrotron radiation facility and the duration time of the excitation light source. In addition, in a sample which is susceptible to radiation damage such as an organic material or a sample which is easy to change with time, the measurement is hindered for a long time, and in many cases, a very weak signal is not sufficiently captured.

It is known that advanced doping techniques are used in the research of new semiconductor materials and superconducting materials, and that even a very small amount of dopant can bring about a great change in the material. Capturing feeble signals from such dopants is extremely important in the development of new materials.

Further, in the study of micro, nanodevices, polycrystalline materials in which a large number of micro domains are formed, multi-magnetic-domain materials, etc., micro region analysis using a microprobe or a field limiting aperture is important. However, a decrease in signal intensity is unavoidable when trying to measure a smaller area. For these reasons, improving sensitivity is one of the most important points in the development of new electron spectroscopy apparatuses.

In an electron spectroscopy apparatus, it is possible to measure the emission angle distribution in addition to the measurement of the energy distribution of electrons emitted from a sample. Information on the composition of elements can be obtained by measuring the energy distribution, and information on the composition in the depth direction and electronic state information can be obtained by measuring the emission angle distribution. Further, since the momentum in the in-plane direction of a sample is preserved in the photoelectron emission process, information on the momentum of electrons in the substance can be obtained by measuring the kinetic energy of the photoelectrons and the emission angle. By irradiating the sample with ultraviolet rays or X-rays and measuring the kinetic energy and emission angle distribution of photoelectrons by adjusting the energy to the valence band, it is possible to evaluate the energy band structure of the substance and almost determine the properties of the substance. Furthermore, in the case of photoelectron emission from the inner shell, when the kinetic energy is several hundred eV or more, a strong peak called a forward focusing peak appears in the direction connecting a photoelectron emitting atom and a scatterer atom around it. By measuring this peak over a wide angular range, it becomes possible to directly capture the state of the atomic arrangement around a specific atom. It is also possible to determine the interatomic distance from the diameter of the diffraction ring formed around the forward focusing peak. As mentioned above, the measurement of the emission angle distribution by the electron spectrometer makes it possible to obtain detailed information at the atomic level, which is difficult with other analytical methods. And it will be a very powerful method for developing new materials and researching unknown physical-characteristics expression-mechanism.

Currently, the emission angle distribution is measured by various methods. In the early days from the 1960s to around 1990, when "high-resolution photoelectron spectroscopy" was established by Kai Siegbahn et al., concentric hemispherical analyzers that accept and analyze only electrons in a specific direction have been widely used. While this concentric hemispherical analyzer can achieve high energy resolution, the measurement of emission angle distribution is performed by rotating the sample or analyzer little by little, so it takes a huge amount of time to acquire data over a wide solid angle. So, it was difficult to measure a wide area of the reciprocal lattice space.

In addition, "angle-resolved photoelectron spectroscopy" has been developed since around 1990 by two different approaches. One was to introduce new technology in the flow of development of the above "high resolution photoelectron spectroscopy", and the other was to develop a new method focusing on angle distribution measurement.

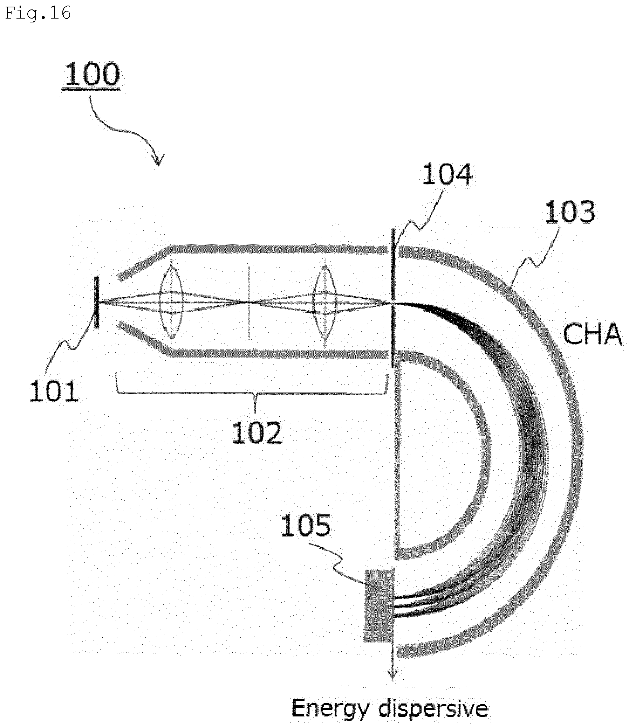

FIG. 16 is a schematic view of an angle-resolved electron spectrometer developed based on the former idea. The basic part of the angle-resolved electron spectrometer 100 is composed of an input lens 102 that accepts and focuses electrons emitted from the sample 101, a concentric hemispherical analyzer (CHA) 103 composed of an inner sphere and an outer sphere, a slit 104 provided at the entrance of the concentric hemispherical analyzer 103 and a detector 105 provided at the exit of the concentric hemispherical analyzer 103. For measurement, "microscopic spectrum mode" (also called Transmission mode or Spatial mode) in which two-dimensional information on the position dependence of the energy spectrum can be obtained at once and "Angle-resolved spectrum mode" (also called Diffraction mode or Angular mode) in which two-dimensional information on the angular distribution of the energy spectrum can be obtained at once are used.

Switching between the microscopic spectrum mode and the angle-resolved spectrum mode is performed by the lens voltage. The lens voltage is adjusted so that the image plane is at the slit position in the microscopic spectrum mode, while the diffraction plane (angle distribution) is at the slit position in the angle-resolved spectrum mode. In the angle-resolved spectrum mode, at the exit of the concentric hemispherical analyzer 103, energy dispersion is formed in the direction connecting the entrance and exit, and a one-dimensional angular distribution is formed in the direction perpendicular to the energy dispersion. Here, the angle range that can be measured at one time depends on the acceptance angle of the input lens. The electron spectrometer with the above basic configuration has been developed and sold by several manufacturers and widely used. However, a device using a normal input lens had a problem that spherical aberration is large and it was not possible to measure a wide range of emission angle distribution at one time.

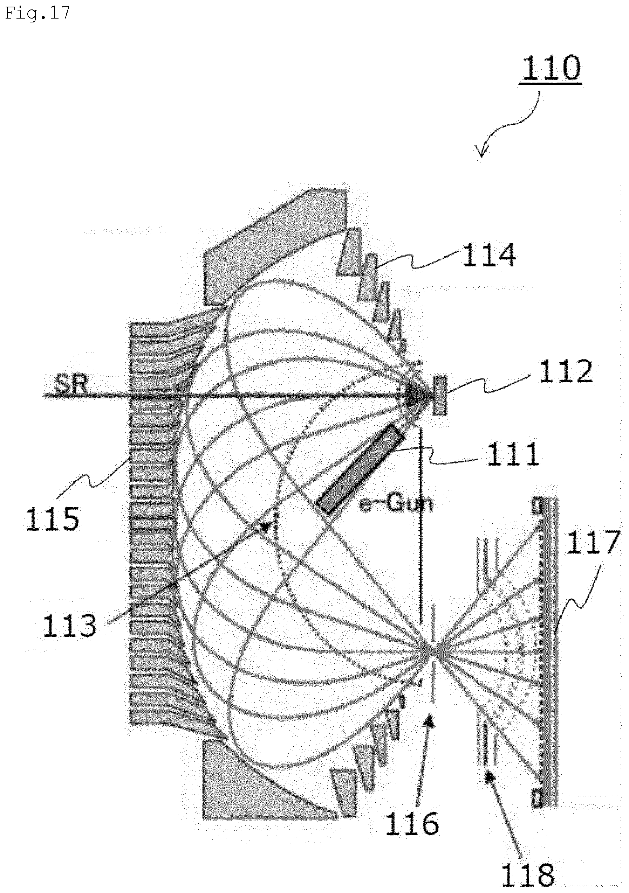

On the other hand, as a method focusing on angle-resolved measurement, an electron spectrometer that measures a two-dimensional emission angle distribution at one time has been developed since around 1990. FIG. 17 is a schematic diagram of a two-dimensional spherical mirror analyzer (DIANA: Display-type Spherical Mirror Analyzer) developed by Daimon et al. (Non-Patent Document 1). In the DIANA 110, the electrons emitted from the sample 112 by the irradiation of the light from synchrotron radiation (SR) light source or the irradiation of the UV lamp or the electron beam from the electron gun 111 are incident on a spherically symmetric electric field formed between the hemispherical grid 113 and its outer ring-shaped electrodes (114, 115). Then the electrons draw an elliptical orbit in it, and those turning 180° pass through the hemispherical grid 113 again and focuses to the position of the aperture 116. The ring-shaped electrodes (114, 115) are provided with a role of blocking electrons having an energy higher than the path energy, simultaneously with a role of forming a spherically symmetric electric field. Electrons with energies lower than the path energy are reversed in direction due to the spherically symmetric electric field, and some of them pass through the aperture 116. Therefore, a high-pass filter for blocking electrons having an energy lower than the pass energy is provided in front of the screen 117. As shown in FIG. 17, the high-pass filter is composed of a plurality of grids including the retarding-voltage grid 118. Only electrons with path energies and energies in the vicinity can pass through the high-pass filter, and the screen 117 displays a two-dimensional emission angle distribution with selected energies. DIANA has an acceptance angle of $\pm 50°$ or $\pm 60°$, and is characterized in that the two-dimensional emission angle distribution can be measured at once without distortion over the large solid angle. Its ability was demonstrated in the measurement of band dispersion structure using vacuum ultraviolet to soft X-ray light (Non-Patent Documents 2 and 3) and the measurement of atomic arrangement structure (Non-Patent Documents 4 and 5). Here, the set path energy ranges from several 10 eV to 1 keV. For a long time, DIANA was the only analyzer capable of measuring the $\pm 50°$ emission angle distribution at one time over this wide energy range.

However, DIANA had a problem that the energy resolution is not so good being 0.5% of the path energy. Atomic structure analysis such as photoelectron holography and stereoscopic photography of atomic arrangement is performed by setting the kinetic energy of photoelectrons to about 500 to 1000 eV, but in this case, the energy resolution is about several eV to 5 eV. With an energy resolution of several eV to 5 eV, it is difficult to separate and distinguish electronic states with near energy peaks such as chemical shifts and spin-orbit splits.

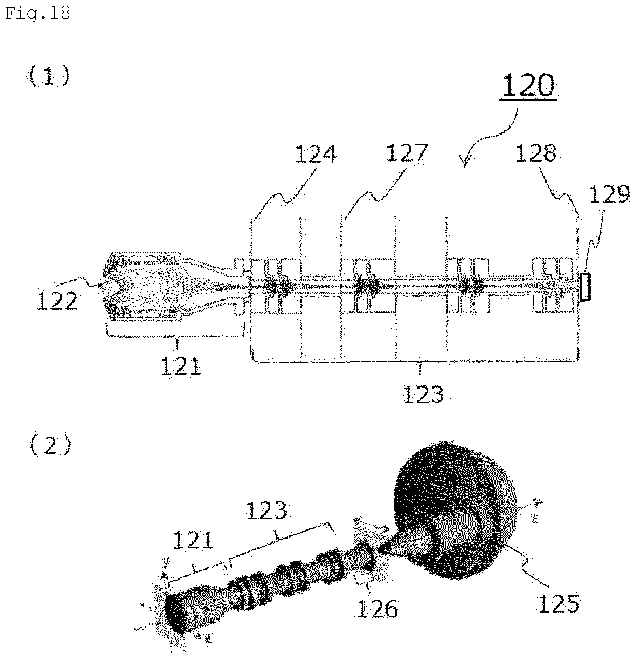

Therefore, a new two-dimensional electron analyzer (DELMA: Display-type ellipsoidal mesh analyzer) has been developed (Non-Patent Document 6). FIG. 18 shows a schematic diagram of a two-dimensional electron analyzer (DELMA). A WAAEL (Wide-acceptance-angle electrostatic lens), which is a wide-angle electrostatic lens 121, has been newly developed for the DELMA 120 and is used as an objective lens. An ellipsoidal mesh electrode 122 with a spheroid surface is provided at the entrance of WAAEL, whereby an acceptance angle of $\pm 45°$ is achieved. Unlike the DIANA 110 in FIG. 17, the DELMA 120 has a basic portion composed of lenses, and a plurality of Einzel lenses 123 are arranged after the wide-angle electrostatic lens 121 (WAAEL). The energy analysis is performed by inserting the aperture 124 at the exit position of the wide-angle electrostatic lens 121 (WAAEL). The possible energy resolution in this case is about 0.3%.

In the DELMA 120, the measurement is performed in the "microscopic imaging mode" in which the two-dimensional real space image of the sample can be acquired and the "angle distribution mode" in which the two-dimensional emission angle distribution information can be acquired. In the microscopic imaging mode, a magnified image of the sample is projected on the screen of the detector 129, and in the angle distribution mode, a two-dimensional emission angle distribution extending to $\pm 45°$ is projected on the screen of the detector 129. A magnified image of the sample is observed in the microscopic imaging mode, the region to be examined is aligned with the optical axis, and an aperture (124,127) is inserted for the purpose of field limitation. Then, by switching to the angle distribution mode, it becomes possible to measure the two-dimensional emission angle distribution from a specific microscopic region. As shown in FIG. 18 (2), the DELMA is combined with the concentric hemispherical analyzer (CHA) 125 in the same manner as the angle-resolved electron spectrometer shown in FIG. 16, enabling measurement with high energy resolution. The concentric hemispherical analyzer (CHA) 125 is combined so that the sample surface thereof and the detector incident surface 128 of the DELMA 120 coincide with each other. For measurements with high energy resolution, the DELMA detector is retracted so that the two-dimensional emission angle distribution is incident on the input lens of the CHA. At this time, by inserting a slit (not shown) at the entrance of the CHA, a one-dimensional angular distribution in which energy was decomposed can be obtained in the detector (not shown) provided at the exit of the CHA. The lens system of the DELMA 120 is provided with an electrostatic deflector 126. With this, it is possible to obtain a two-dimensional emission angle distribution with high energy resolution by inputting electrons into the CHA while scanning the two-dimensional emission angle distribution, acquiring a large number of one-dimensional angle distributions, and combining them.

The method of obtaining a two-dimensional emission angle distribution by scanning using the electrostatic deflector 126 as described above has also been introduced in the angle-resolved electron spectrometer shown in FIG. 16, and is now widely used.

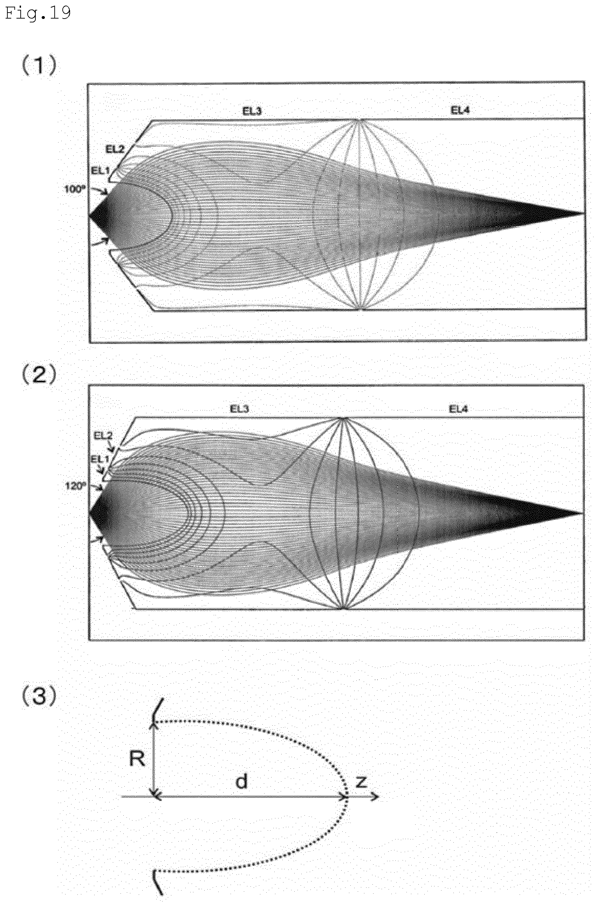

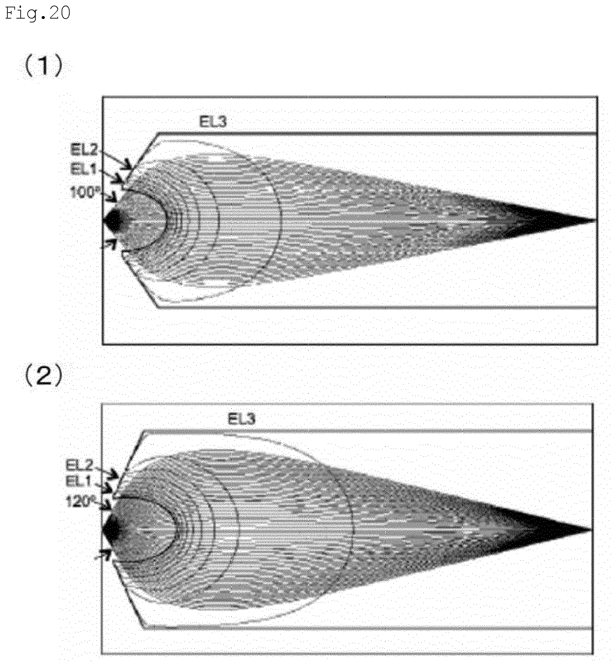

The spherical aberration correction electrostatic lens described in Patent Document 1 and Non-Patent Document 7 is shown in FIGS. 19 (1) and 19 (2), and the spherical aberration correction deceleration type lens described in Patent Document 2 and Non-Patent Document 8 is shown in FIGS. 20 (1) and 20 (2). The spherical aberration correction electrostatic lens shown in FIGS. 19 (1) and 19 (2) is the Einzel lens using an elliptical mesh electrode, and electrons having the same kinetic energy as those emitted from the sample can be obtained at the exit. The spherical aberration correction deceleration type lens shown in FIGS. 20 (1) and 20 (2) is a deceleration type lens using an elliptical mesh electrode, and electrons with about 1/5 of the kinetic energy when emitted from the sample are obtained at the exit. As shown in FIGS. 19 (2) and 20 (2), any of the lenses allows spherical aberration to be corrected over a maximum acceptance angle of $\pm 60°$. Each ellipsoidal mesh electrode is a partial shape of a spheroidal surface whose axis of rotation is the major axis of the ellipsoid. As shown in FIGS. 19 (1) and 20 (1), in the case where the acceptance angle is $\pm 50°$, the shape occupies about half of the spheroidal surface, and as shown in FIGS. 19 (2) and 20 (2), in the case where the acceptance angle is about $\pm 55°$ to $\pm 60°$, the shape occupies more than half of the spheroidal surface. It is difficult to fabricate an ellipsoidal mesh electrode having such a narrow entrance with high definition, high transmittance, and high accuracy. Further, as shown in FIGS. 19 (1) and 20 (1), even if the ellipsoidal mesh electrode has a mesh shape of about half of the spheroid surface, it is not easy to fabricate a mesh having a large ratio (d/R) of the mesh depth d and the opening radius R of the mesh electrode shown in FIG. 19 (3) with high definition, high transmittance, and high accuracy. In the lenses shown in FIGS. 19 (1) and 19 (2) and FIGS. 20 (1) and 20 (2), the ratio (d/R) of the mesh depth d to the opening radius R of the mesh electrode is 1.5 to 2.4.

In the two-dimensional electron analyzer DELMA120 shown in FIG. 18, the spherical aberration correction electrostatic lens shown in FIG. 19 is used. However, the acceptance angle is set to $\pm 45°$. When the acceptance angle is designed to be $\pm 50°$ or $\pm 60°$, the space around the sample is narrowed, and the incident angle of the irradiation beam irradiating the sample is significantly limited. When the angle of the irradiation beam from the sample surface is small, the irradiation spot has a shape that extends long in the incident direction. In order to obtain high energy resolution and high sensitivity, it is desirable that the irradiation spot is as small as possible. In the DELMA, when the sample is faced to the lens, the angle of the irradiation beam from the sample surface is 15°.

The present inventors have already developed a parallel beam two-dimensional electron analyzer having a wide acceptance angle (see Patent Document 3). FIG. 21 is a schematic diagram of the parallel beam two-dimensional electron analyzer. The basic part of the parallel beam two-dimensional electron analyzer 130 is composed of an ellipsoidal mesh electrode 132, a plurality of axisymmetric electrodes 133a to 133e, a planar collimator electrode 134, and a detector 135. The electrons emitted from the sample 131 are taken into the analyzer, parallelized over an acceptance angle of $\pm 60°$, and incident on the planar collimator electrode 134. The planar collimator electrode 134 is a plate or thin film having innumerable elongated holes, and when the wall and surface of the pores are coated with an electron absorbing material such as graphite, only electrons with the path energy and electrons in the vicinity of the path energy pass through the planar collimator electrode 134, and other electrons collide with the planar collimator electrode 134 and are absorbed by the electron absorber. This enables energy analysis, but the energy resolution and sensitivity are in a trade-off relationship, and if the aspect ratio of the holes in the planar collimator electrode 134 is increased to obtain high energy resolution, there is a problem that a significant decrease in the detection sensitivity is unavoidable.

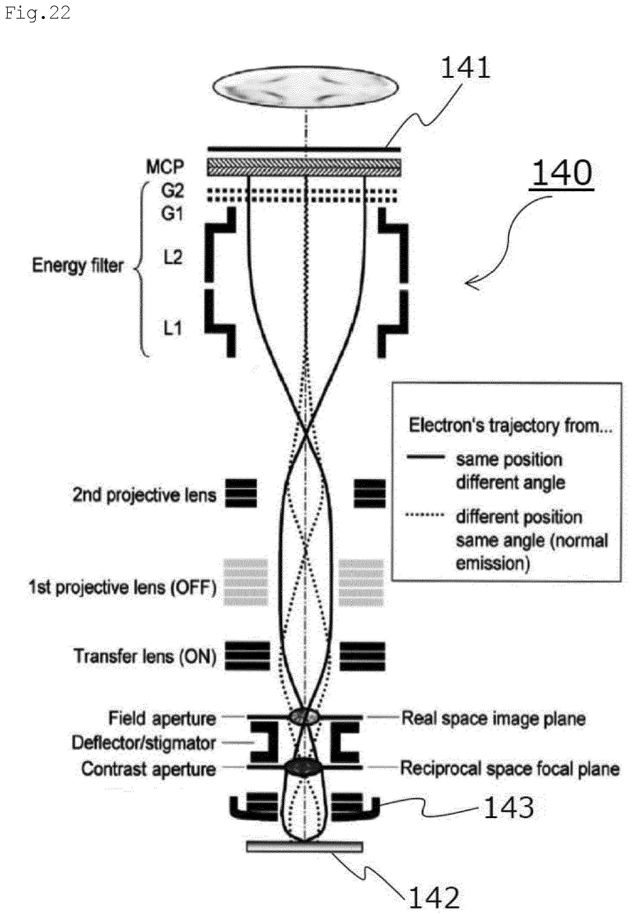

On the other hand, since around 2000, an analyzer that combines a photoemission electron microscope (PEEM) with an energy filter has been developed. FIG. 22 is a schematic configuration diagram of an analyzer in which the PEEM and a high-pass filter are combined (Non-Patent Document 9). A magnified image of the sample 142 or a two-dimensional emission angle distribution is projected on the screen 141 of the analyzer 140 depending on the lens voltage. By using a high-pass filter, Fermi surface mapping can be performed. Furthermore, an analyzer that combines a lens system of the PEEM with a concentric hemispherical analyzer has been developed, and it is possible to efficiently perform ARPES (angle-resolved photoelectron spectroscopy) measurement with high energy resolution. In both of these analyzers and similar analyzers using PEEM technology, a high voltage of several 10 kV is applied between the facing sample 142 and the entrance of the objective lens 143, and the electrons emitted from the sample are accelerated by a strong accelerating electric field at the same time as the emission and are taken into the objective lens 143. As a result, a large acceptance angle is achieved. Specifically, for low-energy electrons of several 10 eV or less, an acceptance angle of approximately $\pm 90°$ is achieved. However, it is difficult to further increase the acceleration voltage from several 10 kV due to problems with the power supply and withstand voltage. As a result, for electrons of several 10 eV or more, there is a problem that the acceptance angle decreases remarkably as the kinetic energy increases.

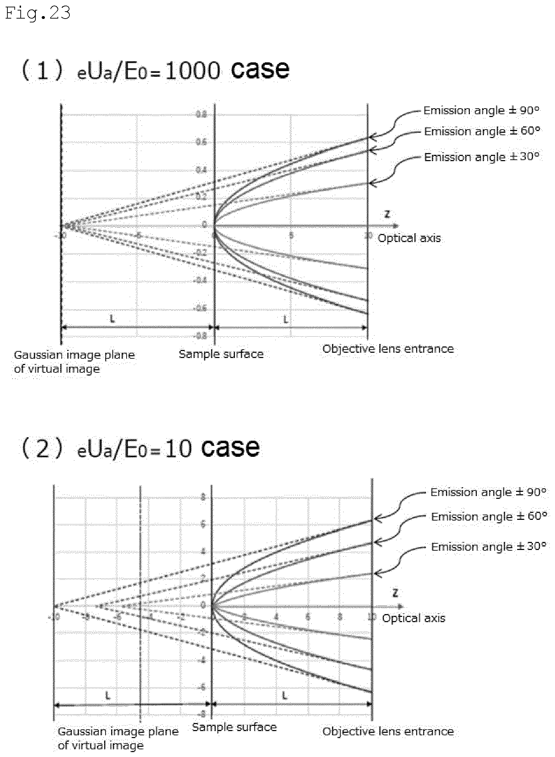

FIG. 23 is a simple calculation result for explaining this. The electron orbit when a uniform accelerating electric field is applied between the sample surface and the entrance of the objective lens is shown. The dotted line is a virtual image line taken from the entrance of the objective lens. FIG. 23 (1) shows results when the ratio ($eUa/E_0$) of the acceleration voltage Ua multiplied by the elementary charge e to the kinetic energy Eo of the electron on the sample surface is 1000, for example, when Eo is 20 eV for an acceleration voltage of 20 kV. In this case, it can be seen that the virtual image lines focus to almost one point. Also, it can be seen that the emission angle on the sample surface is greatly reduced on the virtual image surface. As a result, spherical aberration due to the objective lens is significantly reduced, and a very large acceptance angle is achieved. FIG. 23 (2) shows the results when the ratio ($eUa/E_0$) is 10, for example, when $E_0$ is 2 keV for an acceleration voltage of 20 kV. In this case, a large spherical aberration occurs on the virtual image surface. It can also be seen that the angle of incidence on the objective lens is significantly increased as compared with the case of FIG. 23 (1). As a result, a large spherical aberration is occurred even in the objective lens combined with the cathode lens, and the acceptance angle is remarkably reduced.

[Prior Art]

[Patent Document]

[Patent Document 1] JP 4802340 B
[Patent Document 2] JP 4900389 B
[Patent Document 3] WO 2017-010529 A1

[Non-Patent Document]

[Non-Patent Document 1] H. Daimon,"New display-type analyzer for the energy and the angular distribution of charged particles", Rev. Sci. Instrum. 59, 545 (1988).
[Non-Patent Document 2] F. Matsui, et al., "Three-dimensional band mapping of graphite", Appl. Phys. Lett. 81, 2556 (2002).
[Non-Patent Document 3] F. Matsui, et al., "Atomic-orbital analysis of the Cu Fermi surface by two-dimensional photoelectron spectroscopy", Phys. Rev. B 72, 195417 (2005).
[Non-Patent Document 4] F. Matsui, T. Matsushita and H. Daimon, "Stereo atomscope and diffraction spectroscopy--Atomic site specific property analysis", J. Electron Spectrosc. Relat. Phenom. 178-179, 221 (2010).
[Non-Patent Document 5] F. Matsui, et al., "Selective detection of angular-momentum-polarized Auger electrons by atomic stereography", Phys. Rev. Lett. 114, 015501 (2015).
[Non-Patent Document 6] H. Matsuda, et al., "Development of display-type ellipsoidal mesh analyzer: Computational evaluation and experimental validation", J. Electron Spectrosc. Relat. Phenom. 195 (2014) 382.
[Non-Patent Document 7] H. Matsuda, H. Daimon, M. Kato and M. Kudo, "Approach for simultaneous measurement of two-dimensional angular distribution of charged particles: Spherical aberration correction using an ellipsoidal mesh", Phys. Rev. E 71, 066503 (2005).
[Non-Patent Document 8] H. Matsuda and H. Daimon, "Approach for simultaneous measurement of two-dimensional angular distribution of charged particles. II. Deceleration and focusing of wide-angle beams using a curved mesh lens", Phys. Rev. E 74, 036501 (2006).
[Non-Patent Document 9] M. Kotsugi et al., "Microspectroscopic two-dimensional Fermi surface mapping using a photoelectron emission microscope", Rev. Sci. Instrum., 74, 2754

(2003).

**[Outline of the Invention]**

**[Problems to be Solved by the Invention]**

As described above, in the high energy resolution angle-resolved electron spectrometer (see FIG. 16), the basic part is an input lens that accepts and focuses the electrons emitted from the sample, a concentric hemispherical analyzer consisting of an inner sphere and an outer sphere, a slit provided at the entrance of the concentric hemispherical analyzer, and a detector provided at the exit of the concentric hemispherical analyzer. In the angle-resolved spectroscopy mode, the one-dimensional emission angle distribution that can be measured at one time is determined by the acceptance angle of the input lens. In the case of a conventional input lens that does not use a mesh electrode or a grid electrode, the acceptance angle is about $\pm 10°$ or less. For example, according to Patent Documents 1 and 2, it is known that the acceptance angle can be expanded to about $\pm 50°$ or $\pm 60°$ by using an ellipsoidal mesh, and up to now, spherical aberration correction electrostatic lenses having an acceptance angle of about $\pm 45°$ have been developed. However, with an acceptance angle of about $\pm 45°$, only a region of about 1/4 to 1/3 of the hemispherical solid angle can be captured. Therefore, a larger acceptance angle is desired to measure the emission angle distribution over a wide-angle range in the angle-resolved spectroscopy mode and to improve the sensitivity of the electron spectrometer in the microscopic spectroscopy mode, and ultimately an acceptance angle of $\pm 90°$ (omnidirectional acceptance angle) is desired.

Further, in the spherical aberration correction lenses disclosed in Patent Documents 1 and 2, the ratio (d/R) of the mesh depth d of the ellipsoidal mesh and the aperture radius R of the mesh electrode is required about 1.5 to 1.7 in the case of an acceptance angle of $\pm 50°$ and is required about 2.0 to 2.4 in the case of an acceptance angle of $\pm 60°$. Since it is not easy to fabricate a mesh having such a shape with high definition, high transmittance, and high accuracy, there is a demand for a means for expanding the acceptance angle without using such an ellipsoidal mesh.

On the other hand, the analyzer that combines the PEEM and the concentric hemispherical analyzer achieves a large acceptance angle by applying a high voltage between the sample and the entrance of the objective lens and accelerating and accepting the electrons emitted from the sample. However, when a conventional cathode lens is used in a method of accelerating and accepting electrons as in the PEEM, the acceptance angle decreases significantly with increasing energy, and when the electron kinetic energy $E_0$ to be analyzed is several 10 eV or less, it is almost $\pm 90°$ acceptance angle is achieved, but the acceptance angle drops significantly as the electron kinetic energy Eo increases.

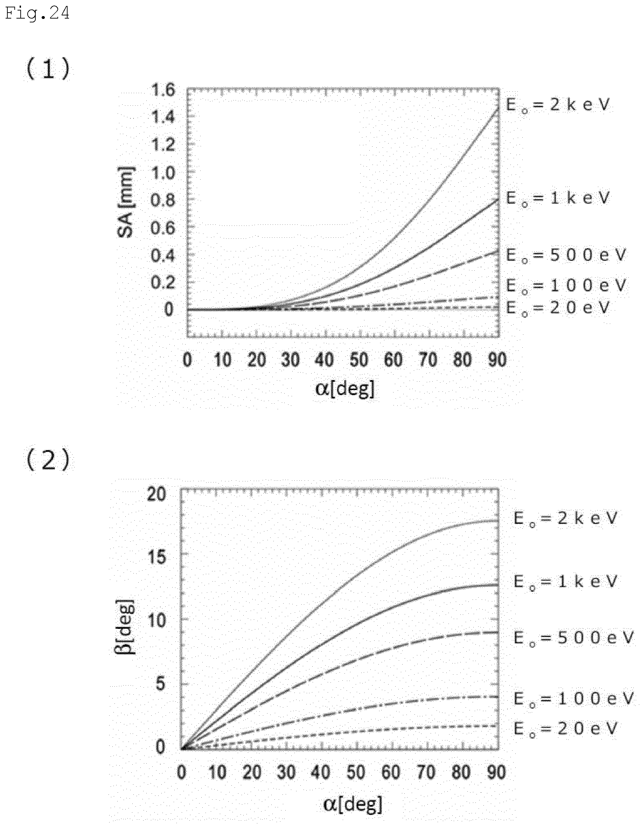

This is understood from FIG. 24. FIGS. 24 (1) and 24 (2) are, respectively, the graphs which show the change of the spherical aberration on the virtual image surface and the change of the emergence angle $\beta$, when the acceleration voltage is 20 kV and the kinetic energy of the emitted electrons on the sample surface is changed from 20 eV to 2 keV in the cathode lens shown in FIG. 23 (the horizontal axis is the emission angle $\alpha$ on the sample surface).

In a high energy resolution analyzer that combines the lens system of the PEEM and the concentric hemispherical analyzer, the lens focusing performance is an important performance that determines the energy resolution and acceptance angle. Even if the spherical aberration of the cathode lens is relatively small, the aberration is magnified by a magnifying lens system provided in the subsequent stage, and the aberration of the lens system itself is added, so that the aberration can be large at the exit of the lens system. A slit having a width of about 1 mm or less is inserted at the entrance of the concentric hemispherical analyzer in order to obtain high energy resolution. Therefore, when a large aberration occurs at the entrance of the concentric hemispherical analyzer, most of the electrons except those having small emission angles on the sample surface are blocked by the slit, and the acceptance angle becomes small. In many cases, the magnification of the input lens used in the concentric hemispherical analyzer is around 5 times. Further, in many input lenses, the acceptance angle with which it is possible to generate a focused beam by suppressing spherical aberration to a small value is about $\pm 5°$ or less.

Looking at FIG. 24 based on such considerations, it can be understood that the kinetic energy of electrons is at most about 100 to 200 eV in order to achieve an omnidirectional acceptance photoelectron analyzer with high energy resolution using a conventional cathode lens. Further, in the energy region of about 500 eV to 1 keV where atomic structure analysis such as photoelectron diffraction and photoelectron holography is often performed, there is a problem that the acceptance angle is about $\pm 20°$ or less.

In view of such circumstances, it is an object of the present invention to provide a cathode lens a spherical aberration correction electrostatic lens that allow an acceptance angle of approximately $\pm 90°$ (omnidirectional acceptance angle) or a very large acceptance angle, in a wide energy range ranging from 0 to 2 keV without using a mesh electrode in which the ratio (d/R) of the depth d to the opening radius R is about 1.5 or more, and to provide a high-energy resolution wide-angle electron analyzer using it.

**[Means to Solve the Objects]**

In order to solve the above problems, the spherical aberration adjustment cathode lens of the present invention is composed of a point source electrode in which a point source is arranged on the lens axis and an extraction electrode for extracting charged particles generated from the point source. In the cathode lens, the point source electrode is one of the following 1a) to 1d), and the extraction electrode is one of the following 2a) and 2b).

(Point source electrode)

1a) A planar electrode perpendicular to the lens axis.

1b) An electrode in which a planar electrode perpendicular to the lens axis has a convex portion in the lens axis direction that is axisymmetric with respect to the axis, and the point source is arranged in the center of the upper portion of the convex portion.

1c) An electrode in which a perforated plate having a through hole on the lens axis or a planar grid is arranged perpendicular to the lens axis.

1d) An axisymmetric or rod-shaped electrode in which a point source is arranged at the tip, and the tip is arranged at the position of the through hole of a perforated plate having a through hole on the lens axis or through the through hole.

(Extraction electrode)

2a) An electrode has a protruding wall portion with an opening surface formed at the end portion, thereof an inner surface shape is formed axially symmetrically in the axial direction from a base surface, which is perpendicular to the lens axis, wherein a planar grid portion 16 is formed on the opening surface.

2b) An electrode has a protruding wall portion with an opening surface formed at the end portion, thereof an inner surface shape is formed axially symmetrically in the axial direction from a base surface, which is perpendicular to the lens axis, wherein the opening surface is formed at the end portion where the inner surface shape of the protruding wall portion is tapered outward.

That is, there are six types of spherical aberration adjustment cathode lenses of the present invention: 1), 2A), 2B), 3A), 3B), and 4) below.

Type 1)

Point source electrode: A planar electrode perpendicular to the lens axis, or an electrode in which a perforated plate having a through hole on the lens axis or a planar grid is arranged perpendicular to the lens axis.

Extraction electrode: An inner surface shape is formed axially symmetrically in the axial direction from the base surface which is perpendicular to the lens axis, and has a protruding wall portion with an opening surface formed at the end portion, and a planar grid is formed on the opening surface.

Type 2A)

Point source electrode: A planar electrode perpendicular to the lens axis, having a convex portion axially symmetrical with respect to the lens axis direction in which the point source is arranged in the upper center of the convex portion.

Extraction electrode: An inner surface shape is formed axially symmetrically in the axial direction from the base surface which is perpendicular to the lens axis, and has a protruding wall portion with an opening surface formed at the end portion, and a planar grid is formed on the opening surface.

Type 2B)

Point source electrode: An axisymmetric or rod-shaped electrode with a point source located at the tip portion, at the position of a through hole of a perforated plate having the through hole on the lens axis or through the through hole.

Extraction electrode: An inner surface shape is formed axially symmetrically in the axial direction from the base surface which is perpendicular to the lens axis, and has a protruding wall portion with an opening surface formed at the end portion, and a planar grid is formed on the opening surface.

Type 3A)

Point source electrode: A planar electrode perpendicular to the lens axis, having a convex portion axially symmetrical with respect to the lens axis direction in which the point source is arranged in the upper center of the convex portion.

Extraction electrode: An inner surface shape is formed axially symmetrically in the axial direction from the base surface which is perpendicular to the lens axis, and has a protruding wall portion with an opening surface formed at the end portion, and the opening surface is formed at the end portion where the inner surface shape of the protrusion wall portion is tapered outward.

Type 3B)

Point source electrode: Point source electrode: An axisymmetric or rod-shaped electrode with a point source located at the tip portion, at the position of a through hole of a perforated plate having the through hole on the lens axis or through the through hole.

Extraction electrode: An inner surface shape is formed axially symmetrically in the axial direction from the base surface which is perpendicular to the lens axis, and has a protruding wall portion with an opening surface formed at the end portion, and the opening surface is formed at the end portion where the inner surface shape of the protrusion wall portion is tapered outward.

Type 4)

Point source electrode: A planar electrode perpendicular to the lens axis, or an electrode in which a perforated plate having through holes on the lens axis or a planar grid is arranged perpendicular to the lens axis.

Extraction electrode: An inner surface shape is formed axially symmetrically in the axial direction from the base surface which is perpendicular to the lens axis, and has a protruding wall portion with an opening surface formed at the end portion, and the opening surface is formed at the end portion where the inner surface shape of the protrusion wall portion is tapered outward.

Here, the protruding wall portion has at least an inner surface shape having a protrusion shape that is axisymmetric from the base surface in the axial direction.

In the spherical aberration adjustment cathode lens of the present invention, when gaseous molecules or particles are used as a point source, in order to supply or recover the gas to be injected into the through hole on the lens axis, the perforated plate and the planar grid should be provided with a gas flow path inside or on the surface.

In the spherical aberration adjustment cathode lens of the present invention, the extraction electrode preferably has an aspect ratio (h/D) of 0.1 to 0.5 between the height h of the protruding wall portion and the diameter D of the plane grid portion. When the aspect ratio (h/D) approaches 0, spherical aberration increases remarkably on the wide-angle side. While when the aspect ratio (h/D) approaches 0.6 or more, a part of the electron orbit on the wide-angle side gets caught on the wall of the protruding wall portion, and the electrons in that orbit cannot pass through the cathode lens.

Further, the dual-type spherical aberration adjustment cathode lens of the present invention is a cathode lens composed of a point source electrode in which a point source is arranged on the lens axis and an extraction electrode for attracting charged particles generated from the point source. In the cathode lens, the point source electrode has a perforated plate or a planar grid having a through hole on the lens axis arranged perpendicular to the lens axis. The extraction electrode has a protruding wall portion in which the inner surface shape is axially symmetrically in the axial direction from a base surface which is perpendicular to the lens axis, and that has an opening surface formed at the end portion thereof, and the first and second electrodes thereof have a planar grid portion formed at the opening surface or an opening surface formed at a tapered protruding wall portion extending from the end portion of the protruding wall portion and expanding outward and at the expanded end portion. Then, the two base surfaces of the first and second electrodes are arranged so as to face each other, and the point source electrode is arranged between the two base surfaces.

In the dual-type spherical aberration adjustment cathode lens of the present invention, when gaseous molecules or particles are used as the point source, in order to supply or recover the gas to be injected into the through hole on the lens axis, the perforated plate and the planar grid should be provided with a gas flow path inside or on the surface.

As in the embodiments described later, a thin film sample is placed on the lens axis of the perforated plate or the planar grid, or the gas is injected from the side to the through hole on the lens axis and irradiated with light. The electrons and ions generated at this time can be detected at a maximum of $4\pi$ steradian (total solid angle) through the first and second electrodes on the left and right of the point source.

In the dual-type spherical aberration adjustment cathode lens of the present invention, it is preferable that the extraction electrode has an aspect ratio (h/D) of 0.1 to 0.5 between the height h of the protruding wall portion and the diameter D of the planar grid portion.

The dual-type spherical aberration adjustment cathode lens of the present invention uses gaseous molecules or particles as the point source, and instead of arranging the perforated plate or the planar grid at the point source electrode, it may be provided with an electric field adjusting means for adjusting the electric field by the applied voltage of the extraction electrode. By this electric field adjusting means, a parallel electric field is formed around the point source, and negatively charged particles are extracted by one extraction electrode and positively charged particles are extracted by the other extraction electrode.

The spherical aberration correction electrostatic lens of the present invention has the spherical aberration adjustment cathode lens of the present invention, a mesh electrode having an axisymmetric concave surface shape facing the protruding wall portion of the extraction electrode, and plural axisymmetric ring-shaped electrodes arranged so that their central axes coincide, and corrects the spherical aberration of the charged particles generated from the point source to generate a focused beam.

The electrostatic lens is composed in combination of an extraction electrode having a protruding wall portion axisymmetric from the base surface where the lens axis is a perpendicular line, a mesh electrode having an axisymmetric concave surface shape, and a plurality of axisymmetric ring-shaped electrode arranged coaxially. Here, in the mesh electrode, the ratio (d/R) of the concave depth d and the opening radius R is 1 or less, and the difficulty in manufacturing the electrode can be reduced.

The dual-type spherical aberration correction electrostatic lens of the present invention has the dual-type spherical aberration adjustment cathode lens of the present invention, a mesh electrode having an axisymmetric concave surface shape facing the protruding wall portion of each extraction electrode and plural axisymmetric ring-shaped electrodes arranged so that their central axes coincide, and extracts the charged particles generated from the point source and corrects the spherical aberration to generate a focused beam. In the mesh electrode, the ratio (d/R) of the concave depth d and the opening radius R is 1 or less, and the difficulty in processing can be reduced.

The electron spectrometer according to the first aspect of the present invention includes an electrostatic lens of either the spherical aberration correction electrostatic lens of the present invention or the dual-type spherical aberration correction electrostatic lens of the present invention, an axisymmetric deceleration lens arranged coaxially with the electrostatic lens, an aperture arranged at the exit of the deceleration lens, a planar collimator plate is arranged on the exit side of the aperture and arranged co-axis with the electrostatic lens, an axisymmetric mesh electrode that is arranged coaxially with the electrostatic lens to allow charged particles that have passed through the aperture to enter perpendicularly to the planar collimator plate, and a ring-shaped electrode.

The photoemission electron microscope of the present invention includes an electrostatic lens of either the spherical aberration correction electrostatic lens of the present invention or the dual-type spherical aberration correction electrostatic lens of the present invention, an aperture arranged at the exit of the electrostatic lens, an axisymmetric accelerating lens arranged on the exit side of the aperture and arranged coaxial with the electrostatic lens, a planar collimator plate arranged co-axis with the accelerating lens, an axisymmetric mesh electrode that is arranged coaxially with the electrostatic lens to allow charged particles that have passed through the accelerating lens to enter perpendicularly to the planar collimator plate, and a ring-shaped electrode. However, if a detector is provided at the exit of the concentric hemispherical analyzer, the angle range that can be measured at one time is one-dimensional, so a projection lens system instead of the above detector and the above detector in the subsequent stage thereof are arranged. Furthermore, by inserting a slit or aperture at the exit of the concentric hemispherical analyzer, it is possible to measure the energy-selected $\pm 90°$ two-dimensional emission angle distribution at one time. When an acceptance angle of $\pm 90°$ is achieved over a wide energy range, it becomes possible to extract all the information on the band dispersion structure and atomic arrangement structure of photoelectrons. Further, since the sensitivity is generally proportional to the acceptance solid angle, the sensitivity is greatly improved in the spectrum measurement mode.

The electron spectrometer according to the second aspect of the present invention includes an electrostatic lens of either the spherical aberration correction electrostatic lens of the present invention or the dual-type spherical aberration correction electrostatic lens of the present invention, an axisymmetric deceleration lens arranged coaxial with the electrostatic lens, an aperture arranged at the exit of the deceleration lens, a concentric hemispherical analyzer consisting of inner and outer spheres arranged on the exit side of the aperture.

## [Effects of the Invention]

The cathode lens of the present invention and the spherical aberration correction electrostatic lens using the same have an effect that $\pm 90°$ or a very large acceptance angle can be achieved without using an ellipsoidal mesh with a large ratio (d/R) of the depth d of the mesh electrode and the opening radius R, which is difficult to fabricate with high definition, high transmittance, and high precision. Further, even if the kinetic energy of the electron to be analyzed is as large as several hundred eV or more, which is suitable for atomic structure analysis such as photoelectron holography, it is the effect that $\pm 90°$ or a very large acceptance angle can be achieved.

In the conventional wide-angle acceptance lens used for PEEM, the acceptance angle of $\pm 90°$ can be achieved only when the kinetic energy of electrons is several 10 eV or less, but the spherical aberration correction electrostatic lens of the present invention can achieve the acceptance angle of $\pm 90°$ up to at least about 2 keV. The spherical aberration correction electrostatic lens of the present invention can accept omnidirectional ($\pm 90°$) electrons emitted from the sample, correct spherical aberration over all angles, and generate a focused beam with an opening angle of about $\pm 10°$ or less. Further, the spherical aberration correction electrostatic lens of the present invention can be easily combined with the concentric hemispherical analyzer of the conventional angle-resolved electron spectrometer, and has an effect that a high-energy resolution electron spectrometer with omnidirectional acceptance can be realized in a wide energy range. As a result, in the angle distribution mode, the emission angle distribution over the omnidirectional acceptance angle ($\pm 90°$) can be measured at once even in a relatively high energy region of about 500 to 1000 eV, which is often used in the measurement of photoelectron diffraction and photoelectron holography.

Further, the mesh electrode used in the spherical aberration correction electrostatic lens of the present invention can significantly reduce the ratio (d/R) of the mesh depth d to the aperture radius R as compared with the mesh electrode used in the conventional spherical aberration correction electrostatic lens. Specifically, the ratio (d/R) can be reduced to 1.0 or less. This greatly reduces the difficulty of processing the mesh electrode, and makes it possible to manufacture a mesh electrode having high definition, high transmittance, and high accuracy.

**[Brief Description of the Drawings]**

[FIG. 1] Schematic diagram of the spherical aberration correction electrostatic lens of the present invention (Embodiment 1) .

[FIG. 2] Explanatory view of the spherical aberration correction electrostatic lens.

[FIG. 3] Explanatory view of the cathode lens.

[FIG. 4] Schematic diagram of the spherical aberration correction electrostatic lens of the present invention (Embodiment 2) .

[FIG. 5] Schematic diagram of the spherical aberration correction electrostatic lens of the present invention (Embodiment 3) .

[FIG. 6] Schematic diagram of the spherical aberration correction electrostatic lens of the present invention (Embodiment 4) .

[FIG. 7] Explanatory view of various parameters.

[FIG. 8] Characteristic explanatory view of acceptance angle that changes according to parameters (1).

[FIG. 9] Characteristic explanatory view of acceptance angle that changes according to parameters (2).

[FIG. 10] Characteristic explanatory view of acceptance angle that changes according to parameters (3).

[FIG. 11] Explanatory view of how to arrange the point source in the upper center of the convex portion in the point source electrode.

[FIG. 12] Schematic diagram of a first embodiment of an electron spectrometer in which the spherical aberration correction electrostatic lens of the present invention and a parallel beam generator are combined.

[FIG. 13] Schematic diagram of a second embodiment of an electron spectrometer in which the spherical aberration correction electrostatic lens of the present invention and a concentric hemispherical analyzer are combined.

[FIG. 14] Schematic diagram of a third embodiment of an electron spectrometer in which the spherical aberration correction electrostatic lens of the present invention and a concentric hemispherical analyzer are combined.

[FIG. 15] Explanatory view of the dual-type spherical aberration adjustment cathode lens of the present invention.

[FIG. 16] Schematic diagram of the conventional angle-resolved electron spectrometer.

[FIG. 17] Schematic diagram of the DIANA that is a conventional two-dimensional display type spherical mirror analyzer.

[FIG. 18] Schematic diagram of the DELMA that is a conventional two-dimensional display type ellipsoidal mesh analyzer.

[FIG. 19] Schematic diagram of a conventional spherical aberration correction electrostatic lens.

[FIG. 20] Schematic diagram of a conventional spherical aberration correction / deceleration type lens.

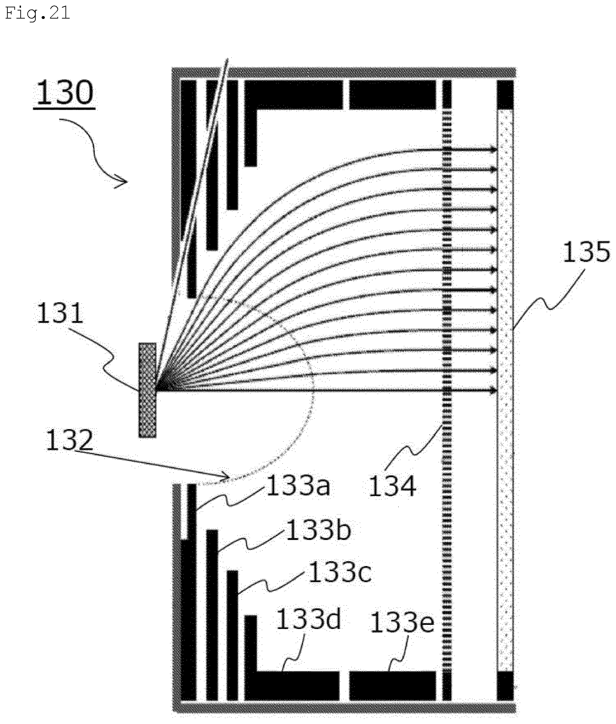

[FIG. 21] Schematic diagram of a conventional parallel beam two-dimensional photoelectron analyzer.

[FIG. 22] Schematic diagram of a photoemission electron microscope PEEM equipped with a conventional energy filter.

[FIG. 23] Schematic diagram of features of a conventional cathode lens used in a conventional PEEM.

[FIG. 24] Schematic diagram of problems of a conventional cathode lens used in a conventional PEEM.

**[Best Mode for Carrying Out the Invention]**

Embodiments of the present invention will be described in detail below with reference to the drawings. The present invention is not limited to the following embodiments and examples of shown in the figure, and the present invention can be variously changed in design.

**[Embodiment 1]**

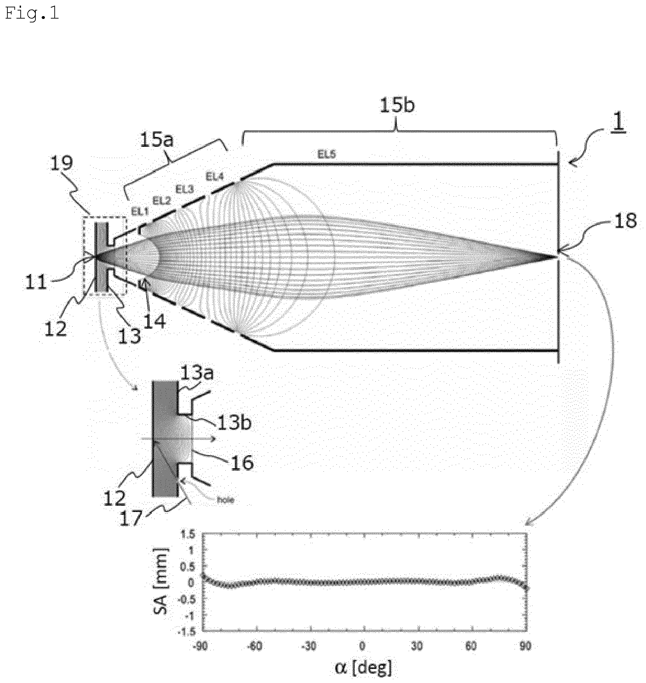

FIG. 1 shows a schematic diagram of an embodiment 1 of the spherical aberration correction electrostatic lens of the present invention. The spherical aberration correction electrostatic lens 1 of the embodiment 1 corresponds to the above-mentioned type 1, and is composed of a point source electrode 12 in which a point source 11 is arranged on the lens axis, an extraction electrode 13 for extracting charged particles generated from the point source 11 in the lens, a mesh electrode 14 having an axisymmetric concave surface shape facing the extraction electrode 13, four axisymmetric ring-shaped electrodes 15a (EL1 to EL4) arranged so that their central axes coincide, and one cylindrical electrode 15b (EL5). Here, "axisymmetric" means that the inner surface shape is axisymmetric. A cathode lens 19 is composed of the point source electrode 12 and the extraction electrode 13.

The point source electrode 12 of the cathode lens 19 is a planar electrode perpendicular to the lens axis, and the extraction electrode 13 has a protruding wall portion 13b in which an inner surface shape is formed axially symmetrically in the axial direction from a base surface 13a, which is perpendicular to the lens axis, and that has an opening surface formed at the end portion thereof, and a planar grid portion 16 is formed at the opening surface of the protruding wall portion 13b. In the spherical aberration correction electrostatic lens, as shown in the enlarged view in the dotted line frame showing the cathode lens 19, the sample is irradiated with light such as ultraviolet rays or X-rays 17, and the electrons emitted from the sample surface are taken in and are focused to the position of the aperture 18. It is also possible to irradiate the sample with an electron beam instead of irradiating with light. However, since the electron beam bends under the action of an electric field even if it is attempted to be irradiated like the irradiation 17 of light, it is desirable to irradiate the electron beam by a method different from that of light. For example, a thin film sample is attached to the position of the hole in the point source electrode with the hole on the lens axis, and the electron beam is irradiated from the left side of the figure. As a result, a method of intaking the electrons appearing on the right side with the spherical aberration correction electrostatic lens is effective. Here, a planar grid may be used as the point source electrode, and the thin film sample may be attached on the lens axis. Further, instead of the thin film sample, gaseous molecules or particles can be used as the sample. When a sample such as gaseous molecules are used, gaseous molecules or the like are injected at the position of the hole of the point source electrode having a through hole. Alternatively, gaseous molecules or the like may be injected onto the lens axis of the planar grid.

The graph shown in FIG. 1 shows SA (Spherical Aberration) with respect to an emission angle $\alpha$ (-90° to 90°) from the point source in the spherical aberration correction electrostatic lens. According to the spherical aberration correction electrostatic lens 1 provided with the cathode lens 19 composed of the point source electrode 12 and the extraction electrode 13 having the above configuration, without using a mesh with a large ratio (d/R) of the depth d of the mesh electrode and the opening radius R (specifically, the mesh with the d/R of about 1.5 or more), an acceptance angle of ±90° can be achieved. In the spherical aberration correction electrostatic lens shown in FIG. 1, the d/R is about 0.90.

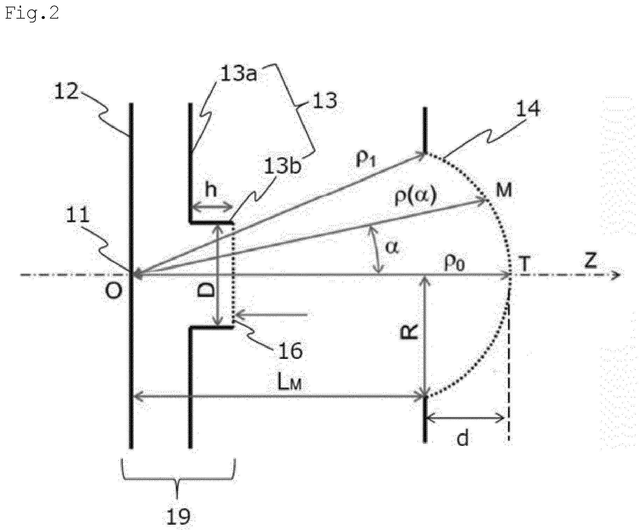

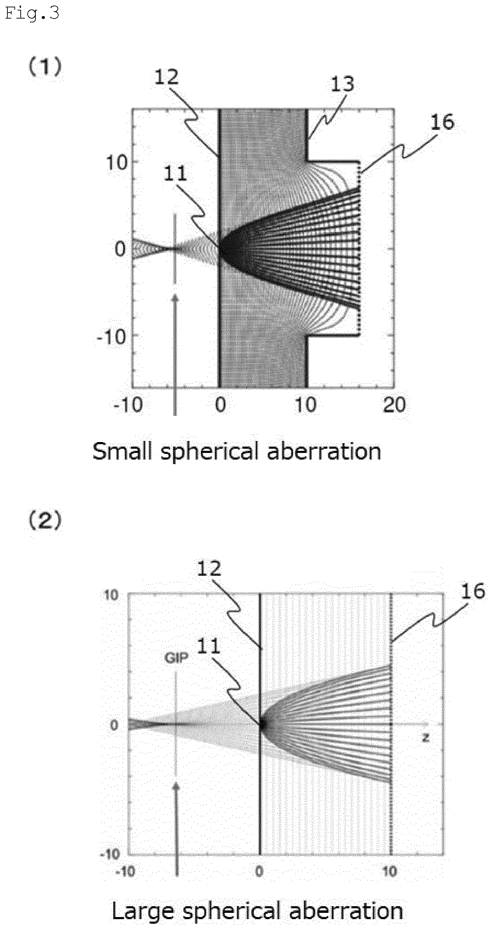

The cathode lens 19 composed of the point source electrode 12 and the extraction electrode 13 will be described with reference to FIGS. 2 and 3. The extraction electrode 13 is characterized by an aspect ratio (h/D) of the height h of the protruding wall portion 13b and the diameter D of the planar grid portion 16. The height h is the height of the protruding wall portion 13b protruding in the axial direction from the base surface 13a of the extraction electrode 13 facing the planar point source electrode 12, that is, the height of the planar grid portion from the base surface 13a. In addition, the extraction electrode does not have a convex shape as shown in FIG. 2, but may have a protrusion shape whose inner surface shape is axisymmetric.

As shown in FIGS. 2 and 3, at the concave side of the inner surface of the extraction electrode 13 having the protruding wall portion and the planar grid portion formed on the opening surface of the protruding wall portion, the planar point source electrode 12 to which the sample to be the point source 11 is attached is arranged so as to face each other with a certain distance from the extraction electrode 13. In the setting where a high voltage is applied between the point source electrode 12 and the extraction electrode 13 to accept the electrons emitted from the sample, over the acceptance angle of ±90° by adjusting the shape, arrangement, and applied voltage of each electrode, it is possible to adjust the spherical aberration in the virtual image to a small value over the angle and generate a focused beam in the lens arranged behind the cathode lens.

In addition, as shown in FIG. 3 (2), the spherical aberration becomes large in the virtual image, when the extraction electrode, facing the planar point source electrode 12 to which the sample to be the point source 11 is attached, is without the protrusion wall portion and with only of the planar grid portion 16. FIGS. 3 (1) and 3 (2) are both the results when the kinetic energy of the electrons at the point source 11 is 1 keV and the voltage between the point source electrode 12 and the planar grid portion 16 is 20 kV.

Here, the calculation conditions of the spherical aberration correction electrostatic lens shown in FIG. 1 are summarized. The kinetic energy of the emitted electrons is set to 1 keV, the planar point source electrode 12 is set to the ground potential, the extraction electrode 13 is set to 20 kV, the four ring-shaped electrodes 15a (EL1 to EL4) and the cylindrical electrode 15b (EL5) are given to the potentials of 20 kV, 10.9 kV, 8.2 kV, 7.2 kV, and 0 V respectively.

The extraction electrode 13, the mesh electrode 14, and the ring-shaped electrode EL1 have the same potential. In addition, the point source electrode 12 may be set to an arbitrary potential Vs instead of the ground potential. In this case, each electrode is given a potential obtained by adding Vs to the above potential.

The distance between the planar point source electrode 12 and the extraction electrode 13 is set to 10 mm, and the aspect ratio h/D (see FIG. 2) of the inner surface convex portion of the extraction electrode 13 is set to 0.3. The diameter D is 20 mm. Assuming that the distance from the origin O to an arbitrary point M of the mesh is $\rho$ and the angle formed by the straight-line OM and the lens axis Z is $\alpha$, the shape of the mesh electrode is given by the following equation.
[Equation 1]

$$\rho(\alpha) = b \sum_{k=1}^{n} a_k \cos^{(k)}\left(\frac{\pi}{2}\frac{\alpha}{\alpha_{max}}\right) + \rho_1 \quad \cdots (1)$$

Here, b is $\rho_0$-$\rho_1$, pi is the square root of (LM$^2$ + R$^2$), $\alpha_{max}$ is arctan (R/L$_M$), a$_1$ + a$_2$ + ... + a$_n$ = 1, L$_M$ is the distance from the origin O to the mesh electrode, R is the opening radius of the mesh electrode, and po are the distances from the origin O to the apex T of the mesh. In the electrostatic lens shown in FIG. 1, n = 3 is set, and each parameter is given by L$_M$ = 37.0 mm, R = 20.0 mm, po = 55.18 mm, a$_1$ = 0.96, a$_2$ = 0.03, and a$_3$ = 0.01.

In the spherical aberration correction electrostatic lens shown in FIG. 1, the voltage applied to each electrode is shown only for the kinetic energy of 1 keV, but in order to correspond to the kinetic energy other than 1 keV, the voltage applied to each electrode may be changed in proportion to the kinetic energy. A considerably high voltage is required for the kinetic energy much higher than 1 keV, but if the kinetic energy is about 2 keV, the applied voltage can be about 40 kV at the maximum, which can be handled sufficiently. Further, even in the energy region higher than 2 keV, it may be possible to cope with the region by preparing a suitable high-voltage power supply and designing it with sufficient withstand voltage.

On the other hand, the application of the lens to the low energy side has no particular problem, changing the applied voltage in proportion to the kinetic energy. However, when the kinetic energy is almost zero or very small, in order to avoid the disturbance of the electron orbit due to the disturbance of the surface potential of the electrode member and the influence of geomagnetism, it is desirable to adjust the voltage applied to each electrode so that it converges to the aperture position with a larger kinetic energy than the kinetic energy at the point source.

By the above method, it is possible to provide a focusing lens having an acceptance angle of ±90° in a wide energy range of at least about 0 to 2 keV. Further, even in the energy region higher than 2 keV, it is possible to provide a focusing lens having an acceptance angle of ±90° if the power supply and withstand voltage resistance allow. Furthermore, even with limited power supply or withstand voltage, optimizing the shape, placement and applied voltage of each electrode may provide the focusing lens with ±90° or a very large acceptance angle.

In addition, In the case of the spherical aberration correction electrostatic lens used in the two-dimensional electron analyzer (DELMA), the ratio (d/R) of the mesh depth d and the aperture radius R of the elliptical surface mesh electrode is about 1.7. In the case of the spherical aberration correction electrostatic lens described in Patent Document 1 and Non-Patent Document 7, and the spherical aberration correction deceleration-type lens described in Patent Document 2 and Non-Patent Document 8, the ratio (d/R) is 1.5 to 2.4. As described above, the ratio (d/R) in the electrostatic lens shown in FIG. 1 is considerably smaller than these ratios. In the case of the electrostatic lens shown in FIG. 1, the difficulty of processing the mesh electrode is greatly reduced, and it is possible to fabricate the mesh electrode with higher accuracy.

When the aspect ratio (h/D) of the extraction electrode 13 of the spherical aberration correction electrostatic lens of this embodiment is set to 0 (zero), the planar grid portion 16 of the extraction electrode 13 and the base surface 13a become flush with each other. As a result, a uniform electric field is formed between the planar point source electrode 12 to which the sample is attached and the extraction electrode 13. When the uniform electric field is formed, spherical aberration will increase significantly on the wide-angle side as compared to the graph shown in FIG. 1. Therefore, it is desirable to adjust the aspect ratio in order to obtain high focusing performance. However, if the aspect ratio is set to 0, there is an advantage that some axis deviation is allowed if the axis is not tilted.

In the spherical aberration correction electrostatic lens of the present embodiment shown in FIG. 1, three ring-shaped electrodes (EL2 to EL4) arranged after the ring-shaped electrode EL1 to which the mesh electrode 14 is attached, and one cylindrical shape electrode 15b (EL5) further arranged after the ring-shaped electrode are combined. However, the number of electrodes to be combined is not limited to this.

As described above, the spherical aberration correction electrostatic lens of the present invention can be designed as an "omnidirectional acceptance spherical aberration correction electrostatic lens" having an acceptance

angle of $\pm 90°$ in the energy range of at least 0 to 2 keV. However, depending on the design or energy, omnidirectional acceptance may not be possible. Therefore, unless otherwise specified, the spherical aberration correction electrostatic lens of the present invention represents the electrostatic lens having an omnidirectional or very large acceptance angle.

**[Embodiment 2]**

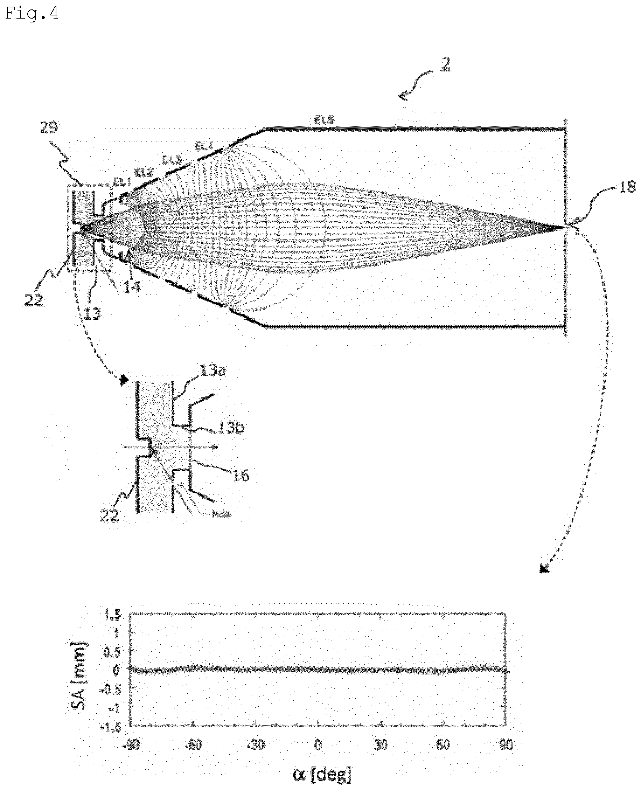

FIG. 4 shows a schematic diagram of an embodiment 2 of the spherical aberration correction electrostatic lens of the present invention. The spherical aberration correction electrostatic lens 2 of the embodiment 2 corresponds to the above-mentioned type 2A, and is composed of a point source electrode 22 in which a point source is arranged on the lens axis, the extraction electrode 13 for extracting charged particles generated from the point source, the mesh electrode 14 having an axisymmetric concave surface shape facing the extraction electrode 13, four axisymmetric ring-shaped electrodes (EL1 to EL4) arranged so that their central axes coincide, and one cylindrical electrode (EL5).

As shown in FIG. 4, a cathode lens 29 has the point source electrode 22 which is a planar electrode perpendicular to the lens axis that has a convex portion axially symmetric in the lens axis direction and has a point source arranged in the center of the upper part of the convex portion. Similar to the spherical aberration correction electrostatic lens 1 shown in FIG.1, the cathode lens 29 has the protruding wall portion 13b in which the inner surface shape is formed in the axial direction axially symmetrically from the base surface 13a perpendicular to the lens axis and in which the opening surface is formed at the end portion, and the extraction electrode 13 in which the planar grid portion 16 is formed at the opening surface of the protruding wall portion 13b. Then, the point source electrode 22 is arranged on the concave side of the inner surface of the extraction electrode 13 so as to face each other with a certain distance from the extraction electrode. By a high voltage applied between the point source electrode 22 and the extraction electrode, electrons emitted from the sample are taken in. In the spherical aberration correction electrostatic lens 2, electrons emitted from the sample surface by irradiation with light such as ultraviolet rays or X-rays are taken over the acceptance angle of $\pm 90°$ and a focused beam is generated at the position of the aperture 18, with spherical aberration corrected to be small, by adjusting the shape, arrangement, and applied voltage of each electrode.

The point source electrode is an axisymmetric electrode in which the point source is arranged at the tip, or a rod-shaped electrode in which the point source is arranged at the tip, and the tip may be arranged at the position of the through hole of the perforated plate having the through hole on the lens axis, or through the through hole. This makes it possible to finely adjust the position of the point source in the lens axis direction. This corresponds to the above-mentioned type 2B. Here, the axisymmetric electrode in which the point source is arranged at the tip portion and the perforated plate having a through hole on the lens axis do not necessarily have to have the same potential. For example, in the case of an insulator sample, the electric field on the surface of the sample becomes non-uniform due to charging, which may greatly affect the measurement result, but this can be eliminated by applying a bias voltage to the sample. Further, as the rod-shaped electrode, a thin straight-shaped electrode that is not axisymmetric is also allowed.

The graph shown in FIG. 4 shows the spherical aberration SA with respect to the emission angle $\alpha$ (-90° to 90°) from the point source in the spherical aberration correction electrostatic lens 2. According to the spherical aberration correction electrostatic lens 2 provided with the cathode lens 29 composed of the point source electrode 22 and the extraction electrode 13 having the above configuration, it can be seen that the acceptance angle of $\pm 90°$ can be achieved without using a mesh having a large ratio (d/R) of the depth d of the mesh electrode and the opening radius R. In the spherical aberration correction electrostatic lens 2, the ratio (d/R) is about 0.96. The spherical aberration correction electrostatic lens 2 makes it possible to make spherical aberration almost zero over incident angles up to $\pm 90°$.

**[Embodiment 3]**

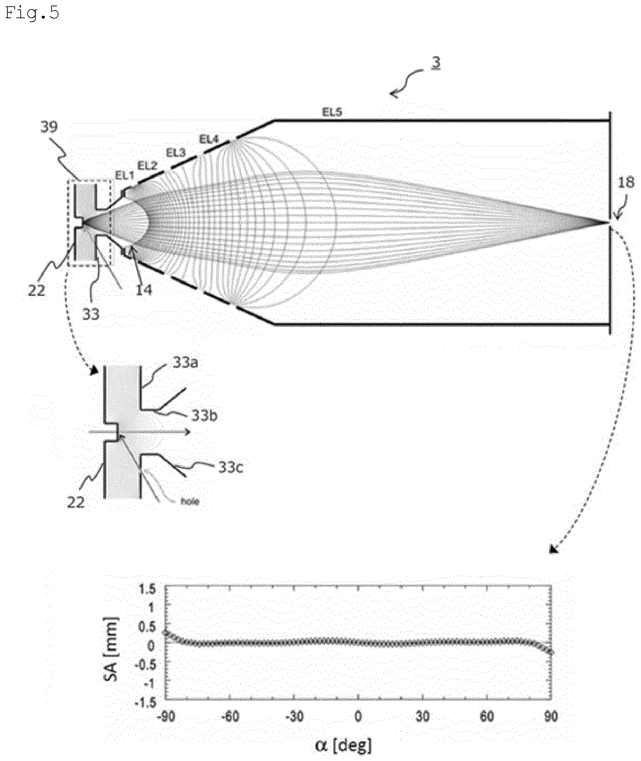

FIG. 5 shows a schematic diagram of an embodiment 3 of the spherical aberration correction electrostatic lens of the present invention. The spherical aberration correction electrostatic lens 3 of the embodiment 3 corresponds to the above-mentioned type 3A, and is composed of the point source electrode 22 in which the point source is arranged on the lens axis, the extraction electrode 33 for extracting charged particles generated from the point source, the mesh electrode 14 having an axisymmetric concave surface shape facing the extraction electrode 33, four axisymmetric ring-shaped electrodes (EL1 to EL4) arranged so that their central axes coincide, and one cylindrical electrode (EL5).

A cathode lens 39 has the point source electrode 22 which is a planar electrode perpendicular to the lens axis that has a convex portion axially symmetric in the lens axis direction and has a point source arranged in the center of the upper part of the convex portion. The cathode lens 39 has the protruding wall portion 33b in which the inner surface shape is formed in the axial direction axially symmetrically from the base surface 33a perpendicular to the lens axis, and the extraction electrode 33 in which a tapered protruding wall portion 33c is formed, which extends from the end of the protruding wall portion 33b and extends outward (the inner surface shape of the protruding wall portion expands outward in a tapered shape). Then, the point source electrode 22 is arranged on the concave side of the inner surface of the extraction electrode 33 so as to face each other with a certain distance from the extraction electrode. By a high voltage applied between the point source electrode 22 and the extraction electrode, electrons emitted from the sample are taken in. In the spherical aberration correction electrostatic lens 3, electrons emitted from the sample surface by irradiation with light such as ultraviolet rays or X-rays are taken over the acceptance angle of ±90° and a focused beam is generated at the position of the aperture 18, with spherical aberration corrected to be small, by adjusting the shape, arrangement, and applied voltage of each electrode.

The point source electrode is an axisymmetric electrode in which the point source is arranged at the tip, or a rod-shaped electrode in which the point source is arranged at the tip, and the tip may be arranged at the position of the through hole of the perforated plate having the through hole on the lens axis, or through the through hole. This makes it possible to finely adjust the position of the point source in the lens axis direction. This corresponds to the above-mentioned type 3B. Here, as with type 2B, the axisymmetric electrode in which the point source is arranged at the tip portion and the perforated plate having a through hole on the lens axis do not necessarily have to have the same potential. Further, as the rod-shaped electrode with the point source arranged at the tip portion, a thin straight-shaped electrode that is not axisymmetric is also allowed.

The graph shown in FIG. 5 shows the spherical aberration SA with respect to the emission angle α (-90° to 90°) from the point source in the spherical aberration correction electrostatic lens 3. According to the spherical aberration correction electrostatic lens 3 provided with the cathode lens 39 composed of the point source electrode 22 and the extraction electrode 33 having the above configuration, it can be seen that the acceptance angle of ±90° can be achieved without using a mesh having a large ratio (d/R) of the depth d of the mesh electrode and the opening radius R. In the spherical aberration correction electrostatic lens 3, the ratio (d/R) is about 0.98. The spherical aberration correction electrostatic lens 3 makes it possible to make spherical aberration almost zero over incident angles up to ±80°.

**[Embodiment 4]**

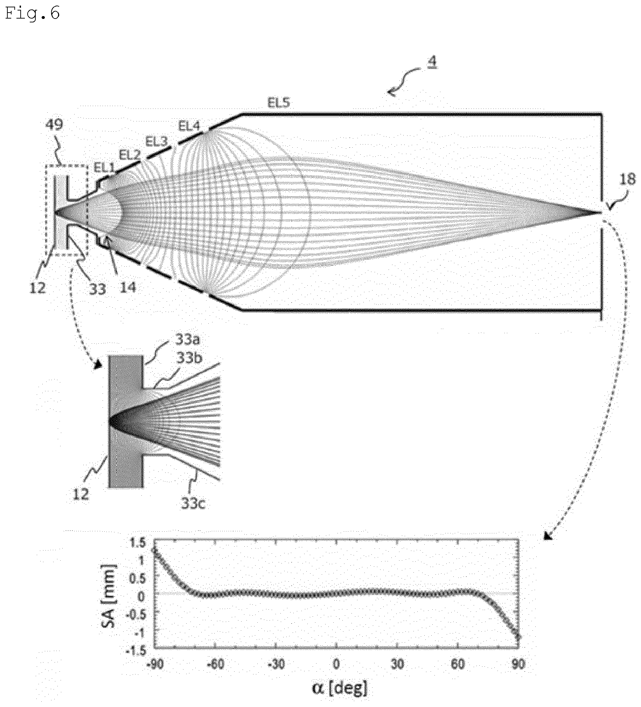

FIG. 6 shows a schematic diagram of an embodiment 4 of the spherical aberration correction electrostatic lens of the present invention. The spherical aberration correction electrostatic lens 4 of the embodiment 4 corresponds to the above-mentioned type 4, and is composed of the point source electrode 12 in which the point source is arranged on the lens axis, the extraction electrode 33 for extracting charged particles generated from the point source, the mesh electrode 14 having an axisymmetric concave surface shape facing the extraction electrode 33, four axisymmetric ring-shaped electrodes (EL1 to EL4) arranged so that their central axes coincide, and one cylindrical electrode (EL5).

A cathode lens 49 has the point source electrode 12 which is a planar electrode perpendicular to the lens axis, the protruding wall portion 33b which is formed in the axial direction axially symmetrically from the base surface 33a perpendicular to the lens axis, and the extraction electrode 33 in which a tapered protruding wall portion 33c is formed, which extends outward from the opening surface of the protruding wall portion 33b. Then, the point source electrode 12 is arranged on the concave side of the inner surface of the extraction electrode 33 so as to face each other with a certain distance from the extraction electrode. By a high voltage applied between the point source electrode 12 and the extraction electrode, electrons emitted from the sample are taken in. In the spherical aberration correction electrostatic lens 4, electrons emitted from the sample surface by irradiation with light such as ultraviolet rays or X-rays are taken over the acceptance angle of ±90° and a focused beam is generated at the position of the aperture 18, with spherical aberration corrected to be small, by adjusting the shape, arrangement, and applied voltage of each electrode.

The graph shown in FIG. 6 shows the spherical aberration SA with respect to the emission angle α (-90° to 90°) from the point source in the spherical aberration correction electrostatic lens 4. According to the spherical aberration correction electrostatic lens 4 provided with the cathode lens 49 composed of the point source electrode 12 and the extraction electrode 33 having the above configuration, it can be seen that a very large acceptance angle can be achieved without using a mesh having a large ratio (d/R) of the depth d of the mesh electrode and the opening radius R. In the spherical aberration correction electrostatic lens 4, the ratio (d/R) is about 0.92. However, in the case of the spherical aberration correction electrostatic lens 4, there remains a problem that large spherical aberration occurs when the acceptance angle is about ±70° or more.

**[Embodiment 5]**

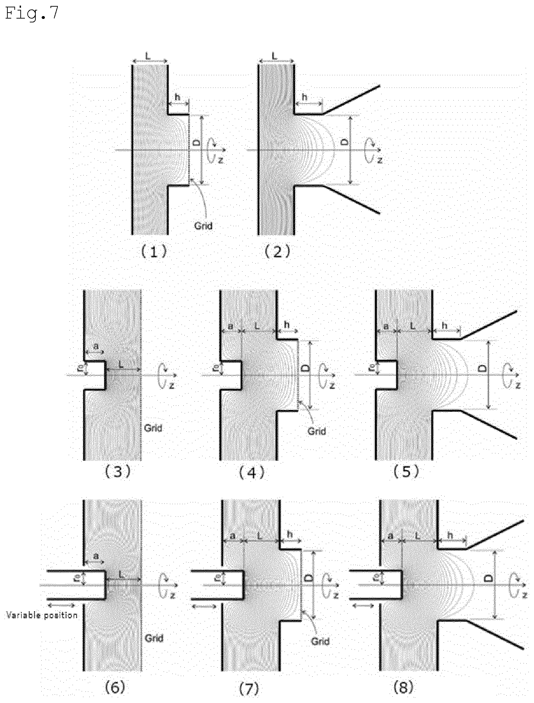

In the cathode lenses (19, 29, 39, 49) of the spherical aberration correction electrostatic lens of the embodiments 1 to 4, the results of simulating the effects of the various parameters shown in FIG. 7 are shown below (Distance L between the point source electrode and the base surface of the extraction electrode, Height a of the convex portion of the point source electrode, Radius $r_0$ of the convex portion of the point source electrode, Height h of the protruding wall portion of the extraction electrode, and Diameter D of the protruding wall portion of the extraction electrode).

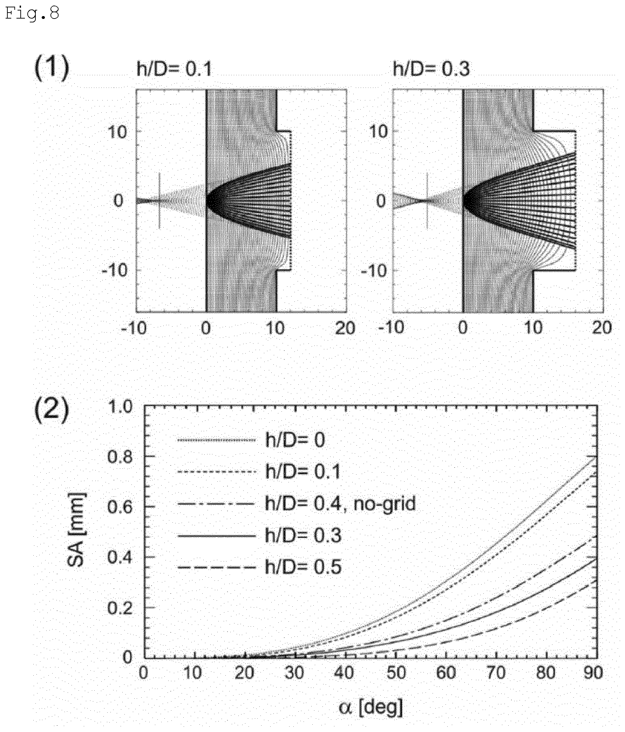

FIGS. 8 to 10 show how the spherical aberration in the virtual image changes due to the change of the above parameters. Each figure (2) shows the spherical aberration SA (mm) with respect to the emission angle α (0° to 90°) from the point source.

In the cathode lens shown in FIG. 7 (1), FIG. 8 takes into consideration the change in the aspect ratio (h/D) of the protruding wall portion. From this figure, it can be seen that the spherical aberration SA decreases as the aspect ratio (h/D) increases from 0 to 0.5. The alternate long and short dash line shown in FIG. 8 (2) is the result when the aspect ratio (h/D) = 0.4 of the cathode lens shown in FIG. 7 (2) without using the grid. Even when the grid is not used, the spherical aberration is smaller than that in the case of the parallel electric field (when h/D = 0 of the cathode lens in FIG. 7 (1)), but the cathode lens of FIG. 7 (1) using the grid can further reduce the spherical aberration by adjusting the aspect ratio (h/D). In addition, the upper limit of the aspect ratio (h/D) is about 0.6. This is because when the aspect ratio (h/D) is about 0.6 or more, a part of the electron orbits on the wide-angle side are caught by the wall of the protruding wall portion, and the electrons in those orbits cannot pass through the cathode lens.

In the spherical aberration correction electrostatic lens shown in FIG. 1, the aspect ratio (h/D) is 0.3. This is the result of optimizing the aspect ratio (h/D) while adjusting various parameters of the mesh electrode, the ring-shaped electrode, and the cylindrical electrode arranged in the subsequent stage of the cathode lens. Further, in the spherical aberration correction electrostatic lens shown in FIG. 6, the aspect ratio (h/D) is 0.4. However, depending on the design of the mesh electrode, ring-shaped electrode, and cylindrical electrode to be combined with the cathode lens, the optimum aspect ratio (h/D) of the spherical aberration correction electrostatic lens of the present invention can vary within the range of 0.1 to 0.5. Further, the size of the diameter D with respect to the distance L between the point source and the base surface of the extraction electrode is determined in the calculation of the optimization of the spherical aberration correction electrostatic lens. In the spherical aberration correction electrostatic lenses of the embodiments 1 to 4, the D/L is around 2.0.

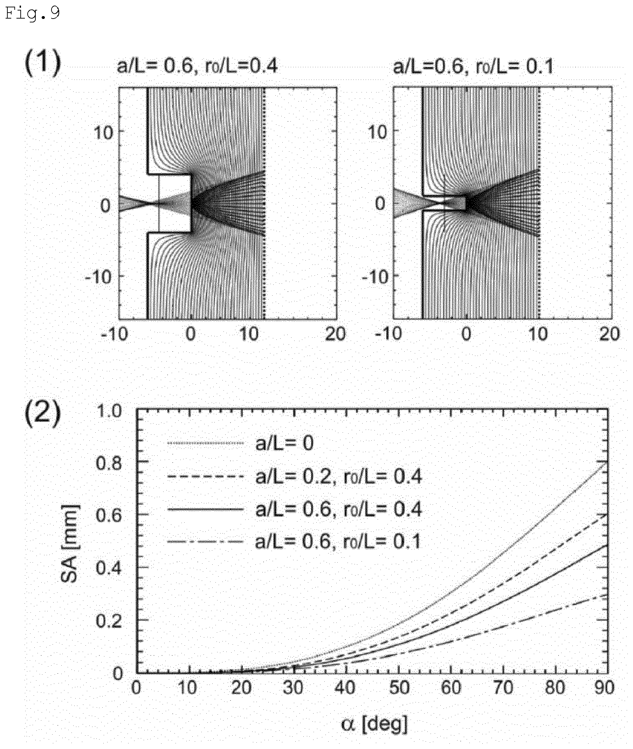

In FIG. 9, the effect of the parameter of the convex portion of the point source electrode having the convex portion axisymmetric in the lens axis direction was taken into consideration. Here, the parameters are the height a and the radius $r_0$ of the convex portion shown in FIG. 7 (3). Increasing the height a reduces the spherical aberration, and decreasing the radius $r_0$ also reduces the spherical aberration. As a result, spherical aberration can be significantly reduced by forming the convex portion into an elongated cylindrical shape. However, in this case, the sample is fixed in a narrow region on the upper surface of the cylinder, which causes a difficulty in practicality.

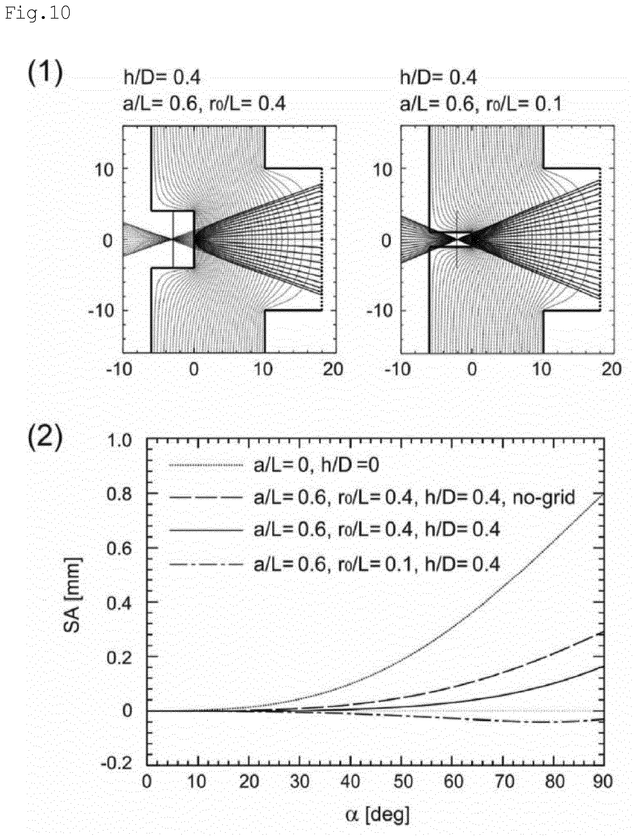

Therefore, in FIG. 10, a combination of the parameter of the convex portion of the point source electrode having the convex portion axisymmetric in the lens axial direction and the parameter of the protruding wall portion of the extraction electrode (aspect ratio (h/D)) is considered. (Corresponding to FIGS. 7 (4) and 7 (5)). In FIGS. 9 (2) and 10 (2), both of the solid line curves are results obtained when the height a and the radius $r_0$ of the convex portion of the point source electrode are set to a/L = 0.6 and $r_0$/L = 0.4, with a and $r_0$ being given as the relative values with respect to the distance L between the point source and the base surface of the extraction electrode. The electron trajectories (virtual images) for these cases are shown on the left side of FIGS. 9 (1) and 10 (1). As can be seen from the comparison of these electron trajectories or the comparison of the solid line curves in FIGS. 9 (2) and 10 (2), spherical aberration can be significantly reduced by combining the point source electrode having an axisymmetric convex portion in the lens axial direction with an extraction electrode having an axisymmetric protruding wall portion. Further, the spherical aberration can be further reduced by reducing the radius $r_0$ of the convex portion of the point source electrode, and negative spherical aberration can be generated as shown by the alternate long and short dash line in FIG. 10 (2). As shown in FIG. 8, the spherical aberration can be considerably adjusted only by the aspect ratio (h/D) of the protruding wall portion of the extraction electrode, but by giving a convex shape to the point source electrode and adding parameters of height a and radius ro, the spherical aberration can be adjusted quite effectively.

In addition, FIGS. 7 (7) and 7 (8) correspond to the above-mentioned types 2B and 3B, respectively. FIG. 7 (6) corresponds to the case where the aspect ratio (h/D) of the above-mentioned type 2B is 0. In the above-mentioned types 2B and 3B, the height a of the point source can be finely adjusted to effectively adjust the spherical aberration.

**[Embodiment 6]**

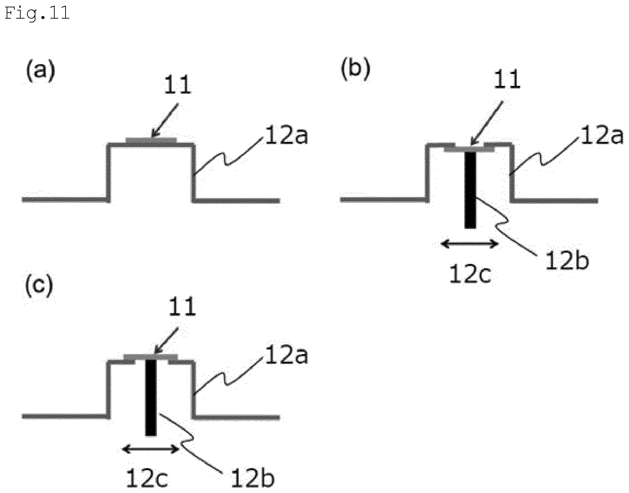

Like the point source electrode in the spherical aberration correction electrostatic lens of the embodiments 2 and 3 described above, for case where the planar electrode perpendicular to the lens axis has the convex portion that is axisymmetric in the lens axis direction and the point source is arranged in the upper center of the convex portion, a method of arranging the point source in the center of the upper part of the convex portion will be described with reference to FIG. 11.

The point source is arranged not only in the manner in which it is put at the upper center of the convex portion 12a as shown in FIG. 11 (a), but also in the manner in which it is set at the upper center of the convex portion 12a via the point source support moving device 12b as shown in FIG. 11 (b) or FIG. 11 (c). The point source support moving device 12b is an axisymmetric or rod-shaped electrode in which the point source 11 is arranged at the tip portion, and the tip is arranged at the position of the through hole of the perforated plate having the through hole on the lens axis or at the position through the through hole. In FIGS. 11 (b) and 11 (c), the sample can be manipulated by using the point source support moving device 12b to finely adjust 12c the position of the point source 11 on the sample.

**[Embodiment 7]**

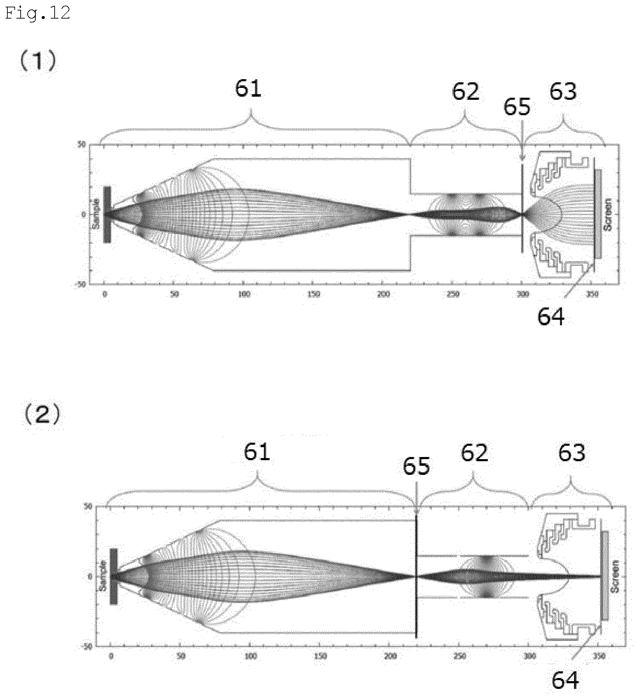

The electron analyzer of this embodiment is provided with the spherical aberration correction electrostatic lens of the embodiment 1 and an "acceleration / deceleration lens" composed of a plurality of axially symmetric electrodes, in the front stage of the conventional parallel beam two-dimensional electron analyzer. Here, the acceleration / deceleration lens is defined as a lens that becomes a deceleration lens or an acceleration lens by switching the voltage. In the electron analyzer shown in FIG. 12, emitted electrons are taken in and focused over the omnidirectional acceptance angle ($\pm 90°$) by the spherical aberration correction electrostatic lens 61 of the present invention, and the two-dimensional emission angle distribution can be measured at one time over the entire angle, with energy being analyzed by the parallel beam two-dimensional electron analyzer 63. The acceleration / deceleration lens 62 gives an effect peculiar to this electron analyzer, as will be described later. As the spherical aberration correction electrostatic lens 61, any of the spherical aberration correction electrostatic lenses shown in the embodiments 1 to 4 may be used.

First, FIG. 12 (1) shows a configuration used in the angle distribution mode. In the angle distribution mode, the acceleration / deceleration lens is used as a "deceleration lens". This deceleration lens is used to reduce the kinetic energy before the electrons enter the planar collimator electrode 64 of the parallel beam two-dimensional electron analyzer 63 to improve the energy resolution. Further, an insertion-type aperture plate or an iris-type aperture 65 having several holes with different diameters is provided at the exit of the acceleration / deceleration lens 62. By the aperture 65 and the deceleration lens, the energy resolution is improved and sensitivity is adjusted. Deceleration increases the spread of the angle of the electron orbit, which is convenient for the parallel beam two-dimensional electron analyzer 63. The reason is that the larger the incident angle, the higher the energy resolution.

Next, FIG. 12 (2) shows a configuration used in the imaging mode. In the imaging mode, it is possible to observe a magnified image of the sample and use as a photoemission electron microscope for aligning the region to be examined on the optical axis. Here, the acceleration / deceleration lens 62 is used as an "acceleration lens". The reason for using the accelerating lens is that the planar collimator electrode 64 is coated with an electron absorbing material in order to block electrons deviated from the parallel beam in the angle distribution mode. In the angle distribution mode, low-energy electrons pass through the planar collimator electrode 64, and the out-of-parallel electrons are absorbed by the electron absorber. While in the imaging mode, a beam close to parallel can be obtained, but a parallel beam as in the angle distribution mode cannot be obtained. Thus, most of the electrons with low energy are absorbed by the electron absorber, and it is difficult to obtain an image.

However, by accelerating the electrons to form an image, the electrons can pass through the planar collimator electrode 64. After observing the magnified image in the imaging mode and aligning the area to be examined on the optical axis, by inserting the aperture 65 into the exit of the spherical aberration correction electrostatic lens 61 for field limitation, the minute region to be investigated is selected as the analysis region. In this state, by setting the angle distribution mode, it is possible to acquire the two-dimensional emission angle distribution of the minute region to be investigated at once over the entire angle. In addition, this analyzer can be designed compactly and can be easily combined with other analyzers, so various changes and applications can be expected.

**[Embodiment 8]**

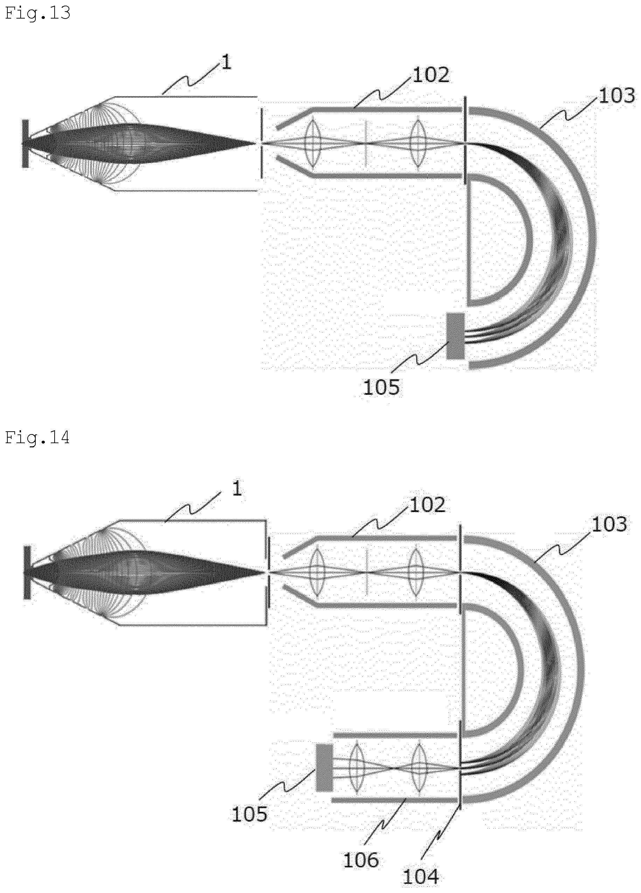

FIG. 13 is a schematic diagram of a second embodiment of the electron analyzer of the present invention. As shown in FIG. 13, the basic portion of the electron analyzer is composed of an input lens 102, a concentric hemispherical analyzer (CHA) 103 composed of an inner sphere and an outer sphere, and a detector 105 provided at the exit of the concentric hemispherical analyzer 103. In the electron analyzer of the present embodiment, the spherical aberration correction electrostatic lens 1 of the embodiment 1 is used in the front stage of the input lens arranged in the front stage of the concentric hemispherical analyzer of the electron analyzer. In the electron analyzer of this embodiment, the focusing angle of the spherical aberration correction electrostatic lens is important. If this focusing angle is larger than the acceptance angle of the input lens, some amount of electron lost occurs with the input lens. Commercial angle-resolved electron spectrometers widely used in basic and applied researches have an acceptance angle of approximately $\pm 6°$ to $\pm 15°$. The spherical aberration correction electrostatic lens of the embodiment 1 shown in FIG. 1 is designed to have a focusing angle of $\pm 10°$, but it can also be designed by setting the focusing angle to $\pm 6°$. This solves the electron-loss problem, but if the design has a small focusing angle, the length of the lens will be long. On the contrary, if there is no problem even if the focusing angle is large, the length of the lens can be short.

Therefore, in the development of a compact electron analyzer, the spherical aberration correction electrostatic lens may be designed according to the acceptance angle of the analyzer to be combined. The sensitivity in the spectrum mode is roughly proportional to the acceptance solid angle, and the acceptance solid angle is proportional to 1-cos ($\theta$) when the acceptance angle is expressed by $\pm \theta$. For that reason, in the electron spectrometer with the acceptance angle of $\pm 6°$, by combining an omnidirectional acceptance spherical aberration correction electrostatic lens with a focusing angle set to $\pm 6°$, the acceptance solid angle can be magnified by (1 - cos (90°)) / (1 - cos (6°)) = 183 times, and the sensitivity becomes 91 to 110 times multiplied by 0.5 to 0.6, which is the estimated transmittance of the spherical aberration correction electrostatic lens.

Similarly, if the electron spectrometer having the acceptance angle of $\pm 15°$ is combined with the spherical aberration correction electrostatic lens of this embodiment, the sensitivity can be expected to be improved by 15 to 18 times. Further, in the angle distribution mode, the one-dimensional emission angle distribution and energy dispersion in the entire range ($\pm 90°$) can be measured at the same time. Further, in the angle distribution mode, the one-dimensional emission angle distribution and energy dispersion in the entire range ($\pm 90°$) can be measured at the same time. For the measurement of the two-dimensional emission angle distribution over the omnidirectional acceptance angle ($\pm 90°$), the scanning method using the electrostatic deflector described above can be used, and it possible to measure the entire two-dimensional emission angle distribution with high energy resolution in the wide energy range. In addition, instead of using the spherical aberration correction electrostatic lens of the embodiment 1, the spherical aberration correction electrostatic lens of any of the embodiments 2 to 4 may be used.

**[Embodiment 9]**

FIG. 14 is a schematic diagram of a third embodiment of the electron analyzer of the present invention. As shown in FIG. 14, similarly to the electron analyzer of the second embodiment shown in FIG. 13, the electron analyzer uses the spherical aberration correction electrostatic lens 1 of the embodiment 1 further before the input lens 102 in the front stage of the concentric hemispherical analyzer composed of the inner sphere and the outer sphere. Unlike the electron analyzer of the second embodiment shown in FIG. 13, the electron analyzer of the third embodiment is provided with a slit or aperture 104 for energy selection at the exit of the concentric hemispherical analyzer (CHA) 103, and the projection lens 106 and the detector 105 are provided in the subsequent stage. Thereby, it possible to measure a two-dimensional emission angle distribution that has been energy-decomposed with high resolution over the wide energy range at once over the omnidirectional acceptance angle ($\pm 90°$).

**[Embodiment 10]**

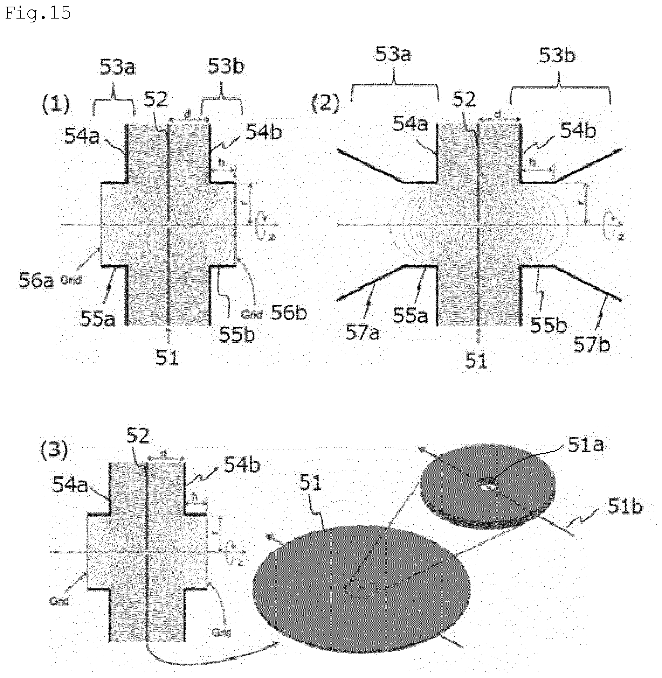

FIG. 15 is a schematic diagram of the dual-type spherical aberration adjustment cathode lens of the present invention. As shown in FIG. 15 (1), the dual-type spherical aberration adjustment cathode lens of the first embodiment is a cathode lens composed of a point source electrode 52 in which the point source is arranged on the lens axis and two extraction electrodes (53a, 53b) for extracting charged particles generated from the point source. As the point source electrode 52, a perforated plate 51 having a through hole on the lens axis is arranged perpendicular to the lens axis. Further, extraction electrodes (53a, 53b) have protruding wall portions (55a, 55b) that are axisymmetric in the axial direction from base surfaces (54a, 54b) whose lens axis are a perpendicular line, and have two left and right first and second electrodes (53a, 53b) in which planar grid portions (56a, 56b) are formed at the opening surface of the protruding wall portion 55, and a point source electrode 52 is arranged in between the two base surfaces (54a, 54b). Further, in the dual-type spherical aberration adjustment cathode lens of the second embodiment, as shown in FIG. 15 (2), the point source electrode 52 has a perforated plate 51 having the through hole on the lens axis, and the plate 51 is arranged perpendicular to the lens axis. Extraction electrodes (53a, 53b) have protruding wall portions (55a, 55b) that are axisymmetric in the axial direction from base surfaces (54a, 54b) whose lens axis are a perpendicular line, and have two left and right first and second electrodes (53a, 53b) in which tapered protrusions (57a, 57b) extending outward from the opening surface of the protruding wall portions (55a, 55b) are formed, and a point source electrode 52 is arranged in between the two base surfaces (54a, 54b).

Here, as shown in FIG. 15 (3), the perforated plate 51 has the through hole 51a in the central portion located on the lens axis, and a thin sample such as graphene is attached, or gas is injected into the through hole 51a on the lens axis, and light is irradiated. The perforated plate 51 is provided with a gas flow path 51b inside the plate in order to supply or recover the injected gas. Electrons and ions generated by light irradiation are detected at a maximum of $4\pi$ steradian (total solid angle) through the left and right electrodes. The central electrode allows the formation of a symmetrical potential distribution and the detection of electrons or similar charged particles at both sides. By changing the way the voltage is applied, it is possible to measure the coincidence of positive and negative charged particles at the left and right. The perforated plate 51 can also irradiate electrons instead of the above-mentioned light by providing a path (not shown) through which electrons pass separately from the gas flow path 51b.

In addition, the distance and the shape of planar grid portions (56a, 56b) of extraction electrodes (53a, 53b) and the base surfaces (54a, 54b) do not have to be symmetrical and may be asymmetric. Further, although the perforated plate 51 is used for the point source electrode 52 on the lens axis, the planar grid may be used instead of the perforated plate 51. Further, instead of providing the gas flow path inside the perforated plate 51, the gas flow path may be provided on the plate surface.

When gaseous molecules or particles are used as the point source, instead of arranging the perforated plate

(or the planar grid) as shown in FIG. 15, the dual-type spherical aberration adjustment cathode lens can be designed to forma parallel electric field around the point source by the adjusting electric field adjustment means in which the electric field is adjusted by the applied voltage of the extraction electrode, and extract negatively charged particles with one extraction electrode and positively charged particles with the other extraction electrode. Here, as the electric field adjustment means, the parallel electric field is arranged by arranging one or a plurality of ring-shaped electrodes between two opposing extraction electrodes, and a parallel electric field can be easily formed by adjusting the voltage applied to the two extraction electrodes and the ring-shaped electrode.

The above-mentioned dual-type spherical aberration adjustment cathode lens, at the subsequent stage of each extraction electrode, similar the spherical aberration correction electrostatic lens shown in FIG. 1, is provided a mesh electrode having an axially symmetric concave surface shape facing the extraction electrode, and a plurality of ring-shaped electrodes and one or more cylindrical electrodes arranged so that the central axes coincide with each other, and therefore charged particles generated from the point source are extracted by each extraction electrode, the spherical aberration is corrected, and a focused beam is generated.

Further, at the subsequent stage of each electrostatic lens of the above-mentioned dual-type spherical aberration correction electrostatic lens, as shown in FIG. 12, electron analyzers can be designed by arranging the "acceleration / deceleration lens" consisting of a plurality of axisymmetric electrodes, and the parallel beam two-dimensional electron analyzer. This electron analyzer makes it possible to accept and analyze charged particles emitted over $4\pi$ steradian (omnidirectional acceptance cone angle) with two electrostatic lenses.

Further, at the subsequent stage of each electrostatic lens of the above-mentioned dual-type spherical aberration correction electrostatic lens, as shown in FIG. 13, electron analyzers can be designed by arranging the input lens, the concentric hemispherical analyzer consisting of the inner sphere and the outer sphere, and the detector at the exit thereof. Additionally, instead of arranging the detector at the exit of each concentric hemispherical analyzer, the design may be such that a slit or aperture for energy selection is provided, and a projection lens and a detector are provided in the subsequent stage. As a result, in a wide energy range, charged particles emitted over $4\pi$ steradians (total solid angles) are extracted by each electrostatic lens, it is possible to provide an electron analyzer that measures a two-dimensional emission angle distribution over all solid angles at once with high energy resolution.

**[Industrial Applicability]**

The present invention is useful for electrostatic lenses, electron spectrometers, and photoemission electron microscopes.

**[Description of Symbols]**

1, 2, 3, 4, 61 Spherical aberration correction electrostatic lens
11 Point source
12, 22, 52 Point source electrode
12a Convex portion
12b Point source support moving device
13, 33, 50, 53a, 53b Extraction electrode
13a, 33a, 54a, 54b Base surface
13b, 33b, 55a, 55b Protruding wall portion
33c, 57a, 57b Tapered protruding wall portion
14 Mesh electrode
15a Ring-shaped electrode
15b Cylindrical electrode
16, 56a, 56b Planar grid portion
18, 65, 116, 124, 127 Aperture
19, 29, 39, 49 Cathode lens
51 Perforated plate
51a Through hole
51b Gas flow path
62 Acceleration / deceleration lens
63 Parallel beam two-dimensional electron analyzer
64 Planar collimator electrode
100 Electron spectrometer

101, 112, 131, 142 Sample
102 Input lens
103 Concentric hemispherical analyzer (CHA)
104 Slit / aperture
105, 135 Detector
106 Projection lens
110 DIANA
111 Electron gun
113 Hemispherical grid
114, 115 Ring-shaped electrode
117, 141 Screen
118 Retarding-voltage grid
120 DELMA
121 Wide-angle electrostatic lens
122, 132 Ellipsoidal mesh electrode
123 Einzel lens
125 Concentric hemispherical analyzer (CHA)
126 Electrostatic deflector
129 Detector
130 Parallel beam two-dimensional electron analyzer
133a - 133e Axisymmetric electrode
134 Planar collimator electrode
140 Analyzer
143 Objective lens

**Claims**

1. A spherical aberration adjustment cathode lens comprising:

    a point source electrode in which a point source is arranged on the lens axis, and
    an extraction electrode for extracting charged particles generated from the point source,
    wherein the extraction electrode has a protruding wall portion that forms an inner surface shape axially symmetrically in the axial direction from a base surface, which is perpendicular to the lens axis, and that has an opening surface formed at the end portion thereof, and a planar grid portion is formed at the opening surface, or the opening surface is formed at the end portion where the inner surface shape of the protrusion wall portion is tapered outward.

2. The spherical aberration adjustment cathode lens according to claim 1, wherein the point source electrode is any of the following;

    a) a planar electrode perpendicular to the lens axis, or
    b) an electrode in which a planar electrode perpendicular to the lens axis has a convex portion that is axisymmetric in the lens axis direction, and the point source is arranged in the center of the upper portion of the convex portion, or
    c) an axisymmetric or rod-shaped electrode in which a point source is arranged at the tip, and the tip is arranged at the position of the through hole of a perforated plate having a through hole on the lens axis or through the through hole.

3. The spherical aberration adjustment cathode lens according to claim 1, wherein the extraction electrodes are first and second extraction electrodes arranged so that the base surfaces face each other, and are dual-type in which the point source electrode is arranged between two base surfaces.

4. The spherical aberration adjustment cathode lens according to claim 1, wherein the point source electrode is a perforated plate having a through hole on the lens axis or a planar grid arranged perpendicular to the lens axis, using gaseous molecules or particles as the point source, in order to supply or recover the gas to be injected into the through hole on the lens axis, the perforated plate and the planar grid are provided with a gas flow path inside or on the surface.

**5.** The spherical aberration adjustment cathode lens according to claim 3, wherein the point source electrode is a perforated plate having a through hole on the lens axis or a planar grid arranged perpendicular to the lens axis, using gaseous molecules or particles as the point source, in order to supply or recover the gas to be injected into the through hole on the lens axis, the perforated plate and the planar grid are provided with a gas flow path inside or on the surface.

**6.** The spherical aberration adjustment cathode lens according to any one of claims 1, 2 and 4, wherein the extraction electrode has an aspect ratio (h/D) of 0.1 to 0.5 between the height h of the protruding wall portion and the diameter D of the planar grid portion.

**7.** The spherical aberration adjustment cathode lens according to claim 3 or 5, wherein the extraction electrode has an aspect ratio (h/D) of 0.1 to 0.5 between the height h of the protruding wall portion and the diameter D of the planar grid portion.

**8.** The spherical aberration adjustment cathode lens according to any one of claims 3, 5 and 7, wherein gaseous molecules or particles are used as the point source, and instead of arranging the perforated plate or the planar grid in the point source electrode, an electric field adjustment means for adjusting the electric field by the applied voltage of the extraction electrode, and thereby a parallel electric field is formed around the point source, negatively charged particles are extracted by one of the extraction electrode, and positively charged particles are extracted by the other extraction electrode.

**9.** A spherical aberration correction electrostatic lens comprising:

the spherical aberration adjustment cathode lens according to any one of claims 1, 2, 4 and 6, and
a mesh electrode having an axisymmetric concave surface shape facing the protruding wall portion of the extraction electrode, and
plural axisymmetric ring-shaped electrodes arranged so that the central axes coincide, and which corrects the spherical aberration of charged particles generated from the point source and generates a focused beam.

**10.** A dual-type spherical aberration correction electrostatic lens comprising:

the spherical aberration adjustment cathode lens according to any one of claims 3, 5, 7 and 8, and
a mesh electrode having an axisymmetric concave surface shape facing the protruding wall portion, and
plural axisymmetric ring-shaped electrodes arranged so that the central axes coincide, and which extracts charged particles generated from the point source at each of the extraction electrodes, corrects the spherical aberration and generates a focused beam.

**11.** The spherical aberration correction electrostatic lens according to claim 9, wherein the ratio (d/R) of the depth d of the concave surface to the opening radius R is 1 or less in the mesh electrode.

**12.** The dual-type spherical aberration correction electrostatic lens according to claim 10, wherein the ratio (d/R) of the depth d of the concave surface to the opening radius R is 1 or less in the mesh electrode.

**13.** An electron spectrometer comprising:

the electrostatic lens of either the spherical aberration correction electrostatic lens according to claim 9 or 11, or the dual-type spherical aberration correction electrostatic lens according to claim 10 or 12;
an axisymmetric deceleration lens arranged coaxially with the electrostatic lens;
an aperture arranged at the exit of the deceleration lens; and
axisymmetric mesh electrodes and ring-shaped electrodes arranged coaxially with the electrostatic lens so that charged particles that have passed through the aperture are vertically incident on the planar collimator plate.

**14.** A photoemission electron microscope comprising:

the electrostatic lens of either the spherical aberration correction electrostatic lens according to claim 9 or 11, or the dual-type spherical aberration correction electrostatic lens according to claim 10 or 12;
an aperture arranged at the exit of the electrostatic lens;
an axisymmetric accelerating lens arranged on the exit side of the aperture and coaxially arranged with the electrostatic lens;
a planar collimator plate arranged on the same axis as the acceleration lens; and
axisymmetric mesh electrodes and ring-shaped electrodes arranged coaxially with the electrostatic lens so that charged particles that have passed through the acceleration lens are vertically incident on the planar collimator plate.

15. An electron spectrometer comprising:

the electrostatic lens of either the spherical aberration correction electrostatic lens according to claim 9 or 11, or the dual-type spherical aberration correction electrostatic lens according to claim 10 or 12;
an axisymmetric deceleration lens coaxially arranged with the electrostatic lens;
an aperture arranged at the exit of the electrostatic lens; and

a concentric hemispherical analyzer which is arranged on the exit side of the aperture and consists of inner and outer spheres.

Fig.1

Fig.2

Fig.3

(1)

Small spherical aberration

(2)

Large spherical aberration

Fig.4

Fig.5

Fig.6

Fig.7

Fig.8

Fig.9

(1)

a/L= 0.6, r₀/L=0.4     a/L=0.6, r₀/L= 0.1

(2)

Fig.10

(1)

(2)

Fig.11

(a)

11

12a

(b)

11

12a

12c

12b

(c)

11

12a

12c

12b

Fig.12

（1）

（2）

Fig.13

Fig.14

Fig.15

Fig.16

Energy dispersive

Fig.17

Fig.18

（1）

（2）

Fig.19

(1)

(2)

(3)

Fig.20

(1)

(2)

Fig.21

Fig.22

**Legend (within figure):**

Electron's trajectory from...

— same position different angle

⋯⋯ different position same angle (normal emission)

**Labels (within figure):**

141

140

MCP

G2

G1

Energy filter { L2

L1

2nd projective lens

1st projective lens (OFF)

Transfer lens (ON)

Field aperture — Real space image plane

Deflector/stigmator

Contrast aperture — Reciprocal space focal plane

143

142

Fig.23

## （1） $_eU_a/E_0 = 1000$ case

Emission angle ± 90°
Emission angle ± 60°
Emission angle ± 30°

z
Optical axis

L            L

Gaussian image plane        Sample surface        Objective lens entrance
of virtual image

## （2） $_eU_a/E_0 = 10$ case

Emission angle ± 90°
Emission angle ± 60°
Emission angle ± 30°

z
Optical axis

L            L

Gaussian image plane    Sample surface        Objective lens entrance
of virtual image

Fig.24

(1)

(2)

<table>
<tr><td colspan="2">**INTERNATIONAL SEARCH REPORT**</td><td>International application No.<br><br>PCT/JP2020/047288</td></tr>
</table>

A. CLASSIFICATION OF SUBJECT MATTER
H01J 37/153(2006.01)i
FI: H01J37/153Z

According to International Patent Classification (IPC) or to both national classification and IPC

B. FIELDS SEARCHED

Minimum documentation searched (classification system followed by classification symbols)
H01J37/153

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2006-324119 A (HITACHI, LTD.) 30 November 2006 (2006-11-30) paragraphs [0004]-[0005], [0012], [0015]-[0016], fig. 4 | 1<br>9, 11, 14-15<br>2-8, 12-13 |
| Y<br>A | JP 8-111199 A (JEOL LTD.) 30 April 1996 (1996-04-30) paragraph [0033], fig. 1, 3-6 | 9, 11, 14-15<br>1-8, 10, 12-13 |
| Y<br>A | US 6104029 A (VG SYSTEMS LTD.) 15 August 2000 (2000-08-15) column 9, line 56 to column 10, line 6, fig. 1-2 | 14<br>1-13, 15 |
| Y<br>A | WO 2006/008840 A1 (NATIONAL UNIVERSITY CORPORATION NARA INSTITUTE OF SCIENCE AND TECHNOLOGY) 26 January 2006 (2006-01-26) paragraphs [0039]-[0042], fig. 6-7 | 14-15<br>1-13 |

☐ Further documents are listed in the continuation of Box C.    ☒ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>05 March 2021 (05.03.2021) | Date of mailing of the international search report<br>16 March 2021 (16.03.2021) |
|---|---|
| Name and mailing address of the ISA/<br>Japan Patent Office<br>3-4-3, Kasumigaseki, Chiyoda-ku,<br>Tokyo 100-8915, Japan | Authorized officer<br><br><br>Telephone No. |

Form PCT/ISA/210 (second sheet) (January 2015)

| INTERNATIONAL SEARCH REPORT | | International application No. | |
|---|---|---|---|
| Information on patent family members | | PCT/JP2020/047288 | |

| Patent Documents referred in the Report | Publication Date | Patent Family | Publication Date |
|---|---|---|---|
| JP 2006-324119 A | 30 Nov. 2006 | (Family: none) | |
| JP 8-111199 A | 30 Apr. 1996 | (Family: none) | |
| US 6104029 A | 15 Aug. 2000 | GB 2328792 A page 20, lines 13-33, fig. 1-2 | |
| WO 2006/008840 A1 | 26 Jan. 2006 | US 2008-0135748 A1 paragraphs [0046]-[0050], fig. 6-7 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 4802340 B
- JP 4900389 B
- WO 2017010529 A1

### Non-patent literature cited in the description

- **H. DAIMON.** New display-type analyzer for the energy and the angular distribution of charged particles. *Rev. Sci. Instrum.,* 1988, vol. 59, 545
- **F. MATSUI et al.** Three-dimensional band mapping of graphite. *Appl. Phys. Lett.,* 2002, vol. 81, 2556
- **F. MATSUI et al.** Atomic-orbital analysis of the Cu Fermi surface by two-dimensional photoelectron spectroscopy. *Phys. Rev. B,* 2005, vol. 72, 195417
- **F. MATSUI ; T. MATSUSHITA ; H. DAIMON.** Stereo atomscope and diffraction spectroscopy--Atomic site specific property analysis. *J. Electron Spectrosc. Relat. Phenom.,* 2010, vol. 221, 178-179
- **F. MATSUI et al.** Selective detection of angular-momentum-polarized Auger electrons by atomic stereography. *Phys. Rev. Lett.,* 2015, vol. 114, 015501
- **H. MATSUDA et al.** Development of display-type ellipsoidal mesh analyzer: Computational evaluation and experimental validation. *J. Electron Spectrosc. Relat. Phenom.,* 2014, vol. 195, 382
- **H. MATSUDA ; H. DAIMON ; M. KATO ; M. KUDO.** Approach for simultaneous measurement of two-dimensional angular distribution of charged particles: Spherical aberration correction using an ellipsoidal mesh. *Phys. Rev. E,* 2005, vol. 71, 066503
- **H. MATSUDA ; H. DAIMON.** Approach for simultaneous measurement of two-dimensional angular distribution of charged particles. II. Deceleration and focusing of wide-angle beams using a curved mesh lens. *Phys. Rev. E,* 2006, vol. 74, 036501
- **M. KOTSUGI et al.** Microspectroscopic two-dimensional Fermi surface mapping using a photoelectron emission microscope. *Rev. Sci. Instrum.,* 2003, vol. 74, 2754